Europäisches Patentamt

European Patent Office

Office européen des brevets

(19)

(11) Veröffentlichungsnummer : **0 422 172 B1**

## (12) EUROPÄISCHE PATENTSCHRIFT

(45) Veröffentlichungstag der Patentschrift :
**22.02.95 Patentblatt 95/08**

(51) Int. Cl.$^6$ : **G01R 33/46,** G01R 33/48, G01R 33/56

(21) Anmeldenummer : **90906133.5**

(22) Anmeldetag : **27.04.90**

(86) Internationale Anmeldenummer :
**PCT/DE90/00309**

(87) Internationale Veröffentlichungsnummer :
**WO 90/13826 15.11.90 Gazette 90/26**

(54) **VERFAHREN ZUR AUFNAHME VON SPINRESONANZSPEKTREN.**

(30) Priorität : **29.04.89 DE 3914351**

(43) Veröffentlichungstag der Anmeldung :
**17.04.91 Patentblatt 91/16**

(45) Bekanntmachung des Hinweises auf die
Patenterteilung :
**22.02.95 Patentblatt 95/08**

(84) Benannte Vertragsstaaten :
**CH DE FR GB LI NL**

(56) Entgegenhaltungen :
EP-A- 0 244 752
EP-A- 0 347 990
US-A- 4 701 708
JOURNAL OF MAGNETIC RESONANCE, volume 76, no. 2, 1 February 1988, Academic Press, Inc., (Duluth, MN, US) ; L.O. SILLERUD et al. : "(13C)-Polarization Transfer Proton NMR Imaging of a Sodium (13C)Formate Phantom at 4.7 Tesla", pp. 380-385.

(56) Entgegenhaltungen :
MAGNETIC RESONANCE IN MEDICINE, volume 3, no. 1, February 1986, Academic Press, Inc., (New York, US) ; C.L. DUMOULIN : "Suppression of Water and Other Noncoupled Spins by Homonuclear Polarization Transfer in Magnetic Resonance Imaging", pp. 90-96.
MAGNETIC RESONANCE IN MEDICINE, volume 9, no. 2, February 1989, Academic Press, Inc., (Duluth, MN, US) ; A. KNÜTTEL et al. : "Single-Scan Volume-Selective Spectral Editing by Homonuclear Polarization Transfer", pp. 254-260.

(73) Patentinhaber : **Bruker Medizintechnik GmbH**
**Silberstreifen**
**D-76287 Rheinstetten (DE)**

(72) Erfinder : **KNÜTTEL, Alexander**
**Eisenbahnstra e 70**
**D-7514 Eggenstein-Leopoldshafen (DE)**

(74) Vertreter : **Witte, Alexander, Dr.-Ing. et al**
**Witte, Weller, Gahlert & Otten**
**Patentanwälte**
**Rotebühlstrasse 121**
**D-70178 Stuttgart (DE)**

EP 0 422 172 B1

## Beschreibung

Die Erfindung betrifft ein Verfahren zur Aufnahme von Kernresonanzspektren von Proben mit mindestens drei Gruppen von Kernen derselben Kernart, von denen eine erste Gruppe mit einer zweiten Gruppe gekoppelt ist, während eine dritte Gruppe mit der zweiten Gruppe ungekoppelt ist, jedoch eine chemische Verschiebung aufweist, die nur mit derjenigen der ersten Gruppe im wesentlichen übereinstimmt, wobei zur alleinigen Darstellung des Signals der ersten Gruppe das Signal der dritten Gruppe unterdrückt wird.

Die Erfindung betrifft ferner ein Verfahren zur Aufnahme von Kernresonanzspektren von Proben mit mindestens drei Gruppen von Kernen, von denen eine erste Gruppe einer ersten Kernart mit einer zweiten Gruppe einer zweiten Kernart gekoppelt ist, während eine dritte Gruppe der ersten Kernart mit der zweiten Gruppe ungekoppelt ist, jedoch eine chemische Verschiebung aufweist, die nur mit derjenigen der ersten Gruppe im wesentlichen übereinstimmt, wobei zur alleinigen Darstellung des Signals der ersten Gruppe das Signal der dritten Gruppe unterdrückt wird.

Die Erfindung betrifft schließlich allgemein ein Verfahren zur Aufnahme von Spinresonanzspektren von Proben mit mindestens drei Gruppen von Spins, von denen eine erste Gruppe mit einer zweiten Gruppe gekoppelt ist, während eine dritte Gruppe mit der zweiten Gruppe ungekoppelt ist, jedoch ein Signal mit einer spektralen Lage aufweist, die nur mit derjenigen der ersten Gruppe im wesentlichen übereinstimmt, wobei zur alleinigen Darstellung des Signals der ersten Gruppe das Signal der dritten Gruppe unterdrückt wird.

In der Technik der Spinresonanz-Spektroskopie ist es bekannt, Spektren, bei denen Signale verschiedener Kerngruppen einander überlagern, zu "editieren". Hierunter versteht man verschiedene Aufnahmetechniken, mit denen es möglich ist, aus überlagerten Spektren Einzelsignale herauszufiltern. Üblicherweise geschieht dies, indem nacheinander mehrere Messungen mit unterschiedlichen Meßparametern ausgeführt und dann unerwünschte Signalanteile durch Differenzbildung eliminiert werden.

Beispiele derartiger Editiertechniken für Kernresonanz-Anwendungen sind in dem Lehrbuch von Sanders, Jeremy K.M. und Brian K. Hunter "Modern NMR Spectroscopy", Oxford University Press, 1987, Seiten 237 bis 259 beschrieben. Weitere derartige Verfahren sind in der EP-A-244 752 und der EP-A-166 559 beschrieben. Bei diesen weiteren bekannten Verfahren werden ungekoppelte Spins durch Differenzbildung zweier Messungen unterdrückt.

Die vorstehend beschriebenen Editiertechniken haben jedoch den gemeinsamen Nachteil, daß zur Aufnahme eines Spektrums mehrere, zeitlich versetzte Messungen mit unterschiedlichen Meßparametern durchgeführt werden müssen. Während dies bei langlebigen chemischen Proben in einem Labor kein wesentliches Problem darstellt, können sich erhebliche Probleme dann ergeben, wenn derartige Kernresonanzspektren an biologischen Proben, nämlich an lebendem Gewebe durchgeführt werden sollen. Dies gilt vor allem dann, wenn in-vivo-Messungen an Patienten durchgeführt werden und Bewegungsartefakte zu Meßwertverfälschungen führen können.

Differenzbildende Meßverfahren haben ferner den prinzipiellen Nachteil, daß infolge der Subtraktion von hohen Störsignalamplituden Meßfehler auftreten können, die in derselben Größenordnung liegen wie das Nutzsignal.

Es ist auch bekannt, Kernresonanzspektren volumenselektiv, d.h. nur für einen bestimmten, räumlich definierten Bereich einer Probe aufzunehmen. Diese Aufnahmetechnik hat besondere Bedeutung in der biologischen Forschung sowie der Medizin. Mit dieser Aufnahmetechnik ist es nämlich möglich, beispielsweise an einem Patienten ein Kernresonanzspektrum eines bestimmten definierten Punktes in einem inneren Organ des Patienten aufzunehmen.

Die Aufnahme von volumenselektiven Kernresonanzspektren ist eine an sich bekannte Technik, Beispiele finden sich im Lehrbuch von Wehrli, Felix W., Derek Shaw und J. Bruce Kneeland "Bio-medical Magnetic Resonance Imaging", Verlag Chemie, 1988, Seiten 1 bis 45 und 521 bis 545.

Aus der US-Z "Journal of Magnetic Resonance", 67 (1986), Seite 148, ist z.B. das sogenannte SPARS-Verfahren und aus der US-Z "Journal of Magnetic Resonance", 68 (1986), Seite 367, ist das sogenannte DIGGER-Verfahren bekannt. Bei diesen bekannten Verfahren handelt es sich um volumenselektive Verfahren, bei denen die Schichten außerhalb des selektierten Volumenbereiches gesättigt werden, so daß nur noch der selektierte Volumenbereich übrig bleibt. Nachteilig bei diesen beiden bekannten Verfahren, insbesondere beim DIGGER-Verfahren, ist, daß eine hohe Hochfrequenzleistung benötigt wird, und bei beiden genannten Verfahren müssen die Vorsättigungs-Hochfrequenzpulse sehr genau eingestellt werden, weil sonst zusätzliche Signale erzeugt werden.

Ein weiteres spezielles Verfahren zur volumenselektiven Aufnahme von Kernresonanzspektren unter Verwendung von drei zeitlich beabstandeten 90°-Hochfrequenz-Impulsen bei gleichzeitigem Anliegen verschiedener Gradienten-Magnetfeld-Impulse in unterschiedlichen Koordinatenrichtungen ist auch in der DE-OS 34 45 689 beschrieben. Bei diesem bekannten Verfahren werden herkömmliche stimulierte Spin-Echos erzeugt.

EP 0 422 172 B1

Weitere ähnliche Verfahren sind aus der US-PS 4 680 546, der US-PS 4 703 270 sowie der US-Z- "Journal of Magnetic Resonance", Vol. 78, Seiten 205 bis 212; Vol. 81, Seiten 333 bis 338; Vol. 60, Seiten 337 bis 341 sowie Vol. 78, Seiten 355 bis 361 zu entnehmen.

Aus der US-Z "Magnetic Resonance in Medicine", 9 (1989), Seiten 254 bis 260, ist es schließlich bekannt, volumenselektive Spektren unter Verwendung eines homonuklearen Polarisationstransfers zu editieren, wobei ein einmaliger Transfer verwendet wird.

Wenn nun das Kernresonanzspektrum an einem homonuklear oder heteronuklear gekoppelten Spinsystem der allgemeinen Form $A_n X_m$ aufgenommen werden soll, wie dies für die biomedizinische Forschung von großem Interesse ist, weil derartige Messungen Rückschlüsse auf den Metabolismus im organischen Gewebe erlauben, so stellt sich oft das Problem der Signalüberlappung. Bei einem homonuklear gekoppelten Spinsystem bestehen beide Kopplungspartner aus derselben Kernart, z.B. aus Protonen ($^1$H), während bei heteronuklear gekoppelten Spinsystemen die Kopplungspartner zu verschiedenen Kernarten gehören, z.B. die A-Gruppe zu den Protonen ($^1$H) und die X-Gruppe zu einem Kohlenstoff-Isotop ($^{13}$C). Bei einem homonuklearen Beispielsfall von Lactat, einem $A_3X$-System, hat z.B. die Methylgruppe ($CH_3$) in etwa dieselbe chemische Verschiebung, d.h. Lage der Linie im Spektrum, wie die $CH_2$-Gruppe von Lipid, weil beide chemischen Verschiebungen ungefähr bei 1,35 ppm liegen. Da die Lipidkonzentration in lebendem Gewebe jedoch wesentlich größer sein kann, verdeckt das $CH_2$-Signal des Lipids das $CH_3$-Signal des Lactats. Entsprechendes gilt allgemein für die Editierung von heteronnuklearen $A_n X_m$-Systemen, z.B. für ein $A_3X$-System wie Methanol mit $^{13}$C-Anreicherung.

Würde man nun im erstgenannten Beispielsfall eine volumenselektive Lactat-Messung in einer Lipid-Umgebung mit den bekannten Editierungstechniken vornehmen, bei denen, wie erwähnt, zwei Messungen in zeitlicher Folge mit unterschiedlichen Parametern vorgenommen werden müssen, so ergäben sich Probleme dann, wenn sich der Patient während dieser beiden Messungen bewegt. Es entstehen dann nämlich Artefakte, durch die beide Messungen unterschiedlich beeinflußt werden, so daß bei einer anschließenden Differenzbildung nicht nur die gewünschten isolierten $CH_3$-Signale des Lactats, sondern auch die unerwünschten Lipid-Artefakte durch Editieren herauspräpariert werden.

Obwohl die Erfindung im Rahmen der vorliegenden Anmeldung anhand einer Anwendung auf dem Gebiet der Kernresonanz (NMR) erläutert wird, versteht sich, daß sie auch bei anderen Formen der Spinresonanz anwendbar ist, insbesondere bei der paramagnetischen Elektronenresonanz (EPR) oder Kern/Elektron-Doppelresonanz-Techniken (ENDOR, ELDOR, NEDOR, Overhauser etc.).

Die Erfindung wird ferner am einfachen Beispiel der skalaren Kopplung (J) dargestellt, es versteht sich jedoch, daß Anwendungen auch bei anderen Kopplungsarten, z.B. der Dipolkopplung, möglich sind.

Der Erfindung liegt die Aufgabe zugrunde, ein Verfahren der eingangs genannten Art dahingehend weiterzubilden, daß mit einer einzigen Impulsfolge volumenselektive Messungen an biologischen Proben, insbesondere an Patienten, möglich sind.

Bei dem eingangs zunächst genannten Verfahren zur Aufnahme von Kernresonanzspektren an homonuklearen Systemen wird diese Aufgabe erfindungsgemäß dadurch gelöst,

- daß eine Impulsfolge von drei Hochfrequenz-Impulsen, vorzugsweise 90°-Hochfrequenz-Impulsen, auf die Probe eingestrahlt wird,
- daß der zweite Hochfrequenz-Impuls derart eingestellt wird, daß die Magnetisierung der Kerne der ersten Gruppe mittels Polarisationstransfer auf die Kerne der zweiten Gruppe übertragen wird,
- daß im Zeitintervall zwischen dem zweiten Hochfrequenz-Impuls und dem dritten Hochfrequenz-Impuls ein für die Kerne der zweiten Gruppe dephasierender, erster Gradienten-Magnetfeld-Impuls auf die Probe ausgeübt wird,
- daß der dritte Hochfrequenz-Impuls derart eingestellt wird, daß die Magnetisierung der Kerne der zweiten Gruppe mittels Polarisationsrücktransfer wieder auf die Kerne der ersten Gruppe übertragen wird und
- daß sodann ein für die Kerne der ersten Gruppe rephasierender, zweiter Gradienten-Magnetfeld-Impuls auf die Probe ausgeübt wird.

Bei dem eingangs als zweites genannten Verfahren zur Aufnahme von Kernresonanzspektren an heteronuklearen Systemen wird die der Erfindung zugrundeliegende Aufgabe einerseits dadurch gelöst,

- daß eine Impulsfolge von fünf Hochfrequenz-Impulsen, vorzugsweise 90°-Hochfrequenz-Impulsen, auf die Probe eingestrahlt wird,
- daß der zweite Hochfrequenz-Impuls und ein dritter Hochfrequenz-Impuls derart eingestellt werden, daß die Magnetisierung der Kerne der der ersten Kernart angehörenden ersten Gruppe mittels Polarisationstransfer auf die Kerne der der zweiten Kernart angehörenden zweiten Gruppe übertragen wird,
- daß im Zeitintervall zwischen dem dritten Hochfrequenz-Impuls und dem vierten Hochfrequenz-Impuls mindestens ein für die Kerne der zweiten Gruppe dephasierender, erster Gradienten-Magnetfeld-Impuls auf die Probe ausgeübt wird,

- daß ein vierter Hochfrequenz-Impuls und ein fünfter Hochfrequenz-Impuls derart eingestellt werden, daß die Magnetisierung der Kerne der zweiten Gruppe mittels Polarisationsrücktransfer wieder auf die Kerne der ersten Gruppe übertragen wird und
- daß sodann ein für die Kerne der ersten Gruppe rephasierender, zweiter Gradienten-Magnetfeld-Impuls auf die Probe ausgeübt wird.

Die der Erfindung zugrundeliegende Aufgabe kann ferner für den allgemeinen Fall der Spinresonanz dadurch gelöst werden,

- daß eine Impulsfolge von mindestens drei HochfrequenzImpulsen, vorzugsweise 90°-Hochfrequenz-Impulsen, auf die Probe eingestrahlt wird,
- daß mindestens der zweite Hochfrequenz-Impuls derart eingestellt wird, daß die Magnetisierung der Spins der ersten Gruppe mittels Polarisationstransfer auf die Spins der zweiten Gruppe übertragen wird,
- daß nach dem zweiten Hochfrequenz-Impuls mindestens ein für die Spins der zweiten Gruppe dephasierender, erster Gradienten-Magnetfeld-Impuls auf die Probe ausgeübt wird,
- daß mindestens ein weiterer der Hochfrequenz-Impulse derart eingestellt wird, daß die Magnetisierung der Spins der zweiten Gruppe alsdann mittels Polarisationsrücktransfer wieder auf die Spins der ersten Gruppe übertragen wird und
- daß schließlich ein für die Spins der ersten Gruppe rephasierender, zweiter Gradienten-Magnetfeld-Impuls auf die Probe ausgeübt wird.

Durch diese Maßnahmen wird die der Erfindung zugrundeliegende Aufgabe vollkommen gelöst. Die Erfindung verwendet nämlich einen Kunstgriff, indem die Magnetisierung der interessierenden ersten Gruppe von Kernen für ein bestimmtes Zeitintervall auf eine andere Gruppe von Kernen, nämlich die zweite Gruppe, durch Polarisationstransfer übertragen wird, deren Linie im Spektrum auf einer anderen chemischen Verschiebung sitzt, bzw. einer anderen Kernart angehört. Durch definierte Dephasierung der Magnetisierung der Kerne der ersten Gruppe wird das Signal dieser Kerne kodiert, um alsdann von der zweiten Gruppe durch Polarisations-Rücktransfer wieder auf die erste Gruppe übertragen und ebenso definiert rephasiert, d.h. wieder dekodiert zu werden, während in dieser Zeit das störende Signal der dritten Gruppe, das im seitherigen spektralen Bereich verblieben war, unterdrückt wird. Mit anderen Worten, es wird die interessierende Information, nämlich die Magnetisierung der Kerne der ersten Gruppe, für eine kurze Zeitdauer in einen Bereich anderer chemischer Verschiebung, nämlich den der zweiten Gruppe, verbracht und durch Dephasierung kodiert, um dann die interessierende Information in ihren ursprünglichen Bereich der chemischen Verschiebung zurückzubringen, während danach die interessierende erste Gruppe rephasiert (dekodiert) wird und die nicht interessierende dritte Gruppe dadurch eine Signallöschung erfährt. Dies ist deswegen möglich, weil nur die interessierende erste Gruppe von Kernen mit der zweiten Gruppe gekoppelt ist und nur diese keine Signallöschung erfährt.

Die Verwendung der Gradienten-Magnetfeld-Impulse hat zum einen den Vorteil, daß diese sogenannten "Spoil-Gradienten" die Magnetisierung der zweiten Gruppe von Kernen nach Einstrahlen des zweiten Hochfrequenz-Impulses dephasieren, so daß alle Phasen gleichmäßig in der xy-Ebene verteilt sind. Damit ist deren durch die ersten beiden 90°-Hochfrequenz-Impulse vorgegebene beliebige Phase relativ zum dritten 90°-Hochfrequenz-Impuls ohne Einfluß und eine Scheibenselektierung in z-Richtung wird erst ermöglicht. Der Einfluß der vorgenannten Dephasierung der Magnetisierung der zweiten Gruppe von Kernen wird dann durch den zweiten rephasierenden Gradienten-Magnetfeld-Impuls (Wirkung auf die Kerne der dritten Gruppe), der zeitlich nach dem dritten 90°-Hochfrequenz-Impuls liegt, wieder rückgängig gemacht.

Im Ergebnis bedeutet dies, daß das gewünschte editierte Signal bereits in einem einzigen Durchgang aufgenommen werden kann, so daß sich beispielsweise Bewegungsartefakte nicht störend auswirken können. Selbstverständlich ist es möglich, mehrere Durchgänge nacheinander aufzunehmen, um eine Erhöhung des Signal-Rauschverhältnisses in an sich bekannter Weise zu erhalten, oder zur Ausmittelung von Phasenfehlern an sich bekannte Techniken mit zyklischer Phasenverstellung anzuwenden, dies hat jedoch nichts damit zu tun, daß grundsätzlich das gesamte editierte Spektrum bereits mit einer einzigen Impulsfolge aufgenommen wird. Da, wie erwähnt, bei dem erfindungsgemäßen Verfahren die unterschiedlichen Verhältnisse hinsichtlich chemischer Verschiebung und Kopplung der ersten und dritten Gruppe von Kernen zur zweiten Gruppe ausgenutzt werden, werden die störenden Signale der dritten Gruppe auch vollkommen unterdrückt.

Im Gegensatz zu den z.B. aus der DE-OS 34 45 689 bekannten Verfahren werden bei der vorliegenden Erfindung keine herkömmlichen, stimulierten Spin-Echos, sondern vielmehr Kohärenz-Transfer-Spin-Echos erzeugt.

Bei einer bevorzugten Ausgestaltung des erfindungsgemäßen Verfahrens wird in an sich bekannter Weise zur volumenselektiven Darstellung die Probe einer Folge von Gradienten-MagnetfeldImpulsen unterschiedlicher Koordinatenrichtung ausgesetzt, und es werden mindestens drei der Hochfrequenz-Impulse scheiben-

EP 0 422 172 B1

selektiv eingestellt.

Diese Maßnahmen haben den Vorteil, daß selektive Messungen an definierten, nahezu punktförmigen Bereichen im Inneren einer Probe, beispielsweise im Inneren eines lebendigen menschlichen Körpers, möglich sind. Es können also auf diese Weise gezielte Messungen an inneren Organen von Patienten vorgenommen werden.

Bei einer weiteren bevorzugten Ausgestaltung des erfindungsgemäßen Verfahrens wird nach dem den Polarisationstransfer bewirkenden Hochfrequenz-Impuls ein hinsichtlich der chemischen Verschiebung für die Kerne der zweiten Gruppe selektiver, weiterer Hochfrequenz-Impuls, vorzugsweise ein 180°-Hochfrequenz-Impuls, eingestrahlt.

Diese Maßnahmen sind dann von besonderem Vorteil, wenn eine vierte Gruppe von Kernen vorhanden ist, die mit der dritten Gruppe gekoppelt ist, so daß an sich infolge des zweiten Hochfrequenz-Impulses auch die störende Magnetisierung der dritten Gruppe durch Polarisationstransfer übertragen wird, und zwar auf die jetzt vorhandene vierte Gruppe von Kernen. Wird nun hingegen der selektive, weitere Hochfrequenz-Impuls eingestrahlt, der aufgrund seiner Selektivität nur die Kerne der zweiten Gruppe erfaßt, so dephasiert die Magnetisierung der zweiten Gruppe gegenüber derjenigen der vierten Gruppe in anderer Weise, so daß diese nicht durch Polarisationstransfer auf die der dritten Gruppe zurücktransferiert wird. Im Ergebnis bedeutet dies, daß zwar die störende Magnetisierung der dritten Gruppe bei Proben mit einer vierten Gruppe von Kernen der beschriebenen Art zunächst auf diese vierte Gruppe durch Polarisationstransfer transferiert wird, jedoch über den Polarisationsrücktransfer nicht wieder in den Bereich der ersten Gruppe zurückgeholt wird, so daß auch bei derartigen Proben das starke überlagerte Signal der dritten Gruppe gelöscht wird.

Bei einer weiteren bevorzugten Ausgestaltung des erfindungsgemäßen Verfahrens mit homonuklear gekoppelten Systemen wird das Verfahren an Lactat-Proben ausgeführt.

Dieser Anwendungsfall ist in der Biomedizin besonders bedeutsam.

Bei einer bevorzugten Weiterbildung der vorstehend genannten erfindungsgemäßen Verfahren wird vor dem Einstrahlen des ersten 90°-Hochfrequenz-Impulses ein für die Kerne der zweiten Gruppe selektiver Hochfrequenz-Vorsättigungs-Impuls und danach ein für diese Kerne dephasierender Gradienten-Magnetfeld-Impuls auf die Probe eingestrahlt.

Diese Maßnahmen haben den Vorteil, daß störende Signale, z.B. von Wasser, unterdrückt werden, die sich hinsichtlich der chemischen Verschiebung in unmittelbarer Nähe der zweiten Gruppe befinden. Die Maßnahmen haben auf den nachfolgenden Polarisationstransfer und Polarisationsrücktransfer keinen Einfluß bzw. unterdrücken nur sowieso nicht beobachtbare Kohärenzen.

Bei einer weiteren bevorzugten Ausgestaltung des erfindungsgemäßen Verfahrens werden der erste und der zweite Gradienten-Magnetfeld-Impuls in der Zeitachse relativ zu den HochfrequenzImpulsen derart positioniert, daß keine stimulierten Echos ungekoppelter Spins erzeugt werden.

Diese Maßnahme hat den Vorteil, daß ein stimuliertes Echo, nämlich von unerwünschten ungekoppelten Spins, die über den zweiten und dritten 90°-Hochfrequenz-Impuls refokussiert werden könnten, wiederum dephasiert wird, weil eine solche unerwünschte Refokussion nur bei symmetrischer Fläche, d.h. dem Produkt aus Intensität und Länge der Gradienten-Magnetfeld-Impulse zu den Hochfrequenz-Impulsen auftreten könnte.

Im übrigen ergeben sich bei dem erfindungsgemäßen Verfahren noch weitere Vorteile, beispielsweise eine Phasenunabhängigkeit aller Impulse, da jeweils vor dem zweiten und dritten 90°-Hochfrequenz-Impuls die Magnetisierung durch Gradienten-Magnetfeld-Impulse dephasiert werden kann. Ferner wirkt sich der Betrag der Hochfrequenz-Feldstärke bei den Hochfrequenz-Impulsen nicht wesentlich auf das Meßergebnis aus, sondern bewirkt allenfalls einen gewissen Signalverlust, so daß das erfindungsgemäße Verfahren auch mit Oberflächenspulen einsetzbar ist. Schließlich ist auch die Zeitdauer unkritisch, die zwischen dem ersten und dem zweiten 90°-Hochfrequenz-Impuls und zwischen dem dritten 90°-Hochfrequenz-Impuls und dem Beginn der Spektrenaufnahme eingestellt wird, weil ein Abweichen vom theoretischen Wert $1/(2J)$ beim $A_nX$-System bzw. $1/(4J)$ beim $A_nX_2$-System nur einen gewissen Signalverlust bedeuten würde, wenn die transversalen Relaxationszeiten $T_2$ sehr viel länger als die Pulssequenz sind. Bei kürzeren Relaxationszeiten $T_2$ können indes kürzere Intervalle günstiger sein.

Es versteht sich schließlich, daß weitere Vorteile erzielt werden können, wenn das erfindungsgemäße Verfahren durch weitere, an sich bekannte Maßnahmen ergänzt wird. Zu diesen Maßnahmen gehört beispielsweise die Aufnahme des vollständigen Echos in zeitlicher Symmetrie um den Punkt herum, der im zeitlichen Abstand $\tau_1$ nach dem dritten 90°-Hochfrequenz-Impuls liegt.

Ferner ist es möglich, durch Variation der Gradienten-Magnetfeld-Impulse und durch Anlegen eines Lesegradienten über dem Echo mit jeweils anschließender Fourier-Transformation in an sich bekannter Weise ein Imaging, d.h. eine bildhafte Darstellung eines zwei-oder dreidimensionalen Bereiches zu erreichen. Das erfindungsgemäße Verfahren läßt sich in bekannte Bildgebungsverfahren integrieren, z.B. in das 2D-FT-Ver-

5

fahren mit Phasen- und Lesegradient oder in das Back-Projection-Verfahren mit Lesegradienten unter variablem Winkel oder auch in das Chemical-Shift-Imaging, d.h. die ortsaufgelöste Spektroskopie mit zwei Phasengradienten (ohne Lesegradient).

Bei einer weiteren bevorzugten Ausgestaltung der zuvor geschilderten erfindungsgemäßen Verfahren wird in der zeitlichen Mitte zwischen dem ersten und dem zweiten Hochfrequenz-Impuls sowie nach dem dritten Hochfrequenz-Impuls jeweils ein 180°-Hochfrequenz-Impuls auf die Probe eingestrahlt.

Diese Maßnahme hat den Vorteil, daß eine Verdoppelung der Signalintensität erreicht wird.

Weitere Vorteile ergeben sich aus der Beschreibung und der beigefügten Zeichnung.

Ein Ausführungsbeispiel der Erfindung ist in der Zeichnung dargestellt und wird in der nachfolgenden Beschreibung näher erläutert. Es zeigen:

| | |
|---|---|
| Fig. 1 | eine äußerst schematisierte Darstellung eines Kernresonanz-Spektrums eines homonuklear gekoppelten $A_3X$-Systems, nämlich von Lactat ($CH_3$-CH(OH)-COOR); |
| Fig. 2 | ein Impulsprogramm zur Erläuterung eines Ausführungsbeispiels des erfindungsgemäßen Verfahrens für ein homonuklear gekoppeltes System; |
| Fig. 3 | eine Darstellung einer ersten Testprobe zur Verifizierung der Eigenschaften des Ausführungsbeispiels des erfindungsgemäßen Verfahrens; |
| Fig. 4 bis 6 | drei an einer Probe gemäß Fig. 3 aufgenommene Kernresonanzspektren; |
| Fig. 7 | eine Darstellung, ähnlich Fig. 3, jedoch für eine andere Testprobe; |
| Fig. 8 bis 10 | drei Spektren, ähnlich den Fig. 4 bis 6, |
| Fig. 11 | eine Darstellung, ähnlich Fig. 2, für eine Variante des dort dargestellten Impulsprogrammes, mit zwei zusätzlichen 180°-Impulsen; |
| Fig. 12 | eine Darstellung, ähnlich Fig. 1, jedoch für ein heteronuklear gekoppeltes System; |
| Fig. 13 | ein Impulsprogramm zur Erläuterung eines Ausführungsbeispiels des erfindungsgemäßen Verfahrens für heteronuklear gekoppelte Systeme; |
| Fig. 14 | eine Variante des Impulsprogramms gemäß Fig. 13; |
| Fig. 15 | eine weitere Variante des Impulsprogramms gemäß Fig. 13; |
| Fig. 16 | ein Kernresonanzspektrum, das nach dem Stand der Technik an einem heteronuklear gekoppelten System aufgenommen wurde; |
| Fig. 17 | ein Kernresonanzspektrum, ähnlich Fig. 16, das jedoch nach dem erfindungsgemäßen Verfahren gemäß Fig. 13 aufgenommen wurde. |

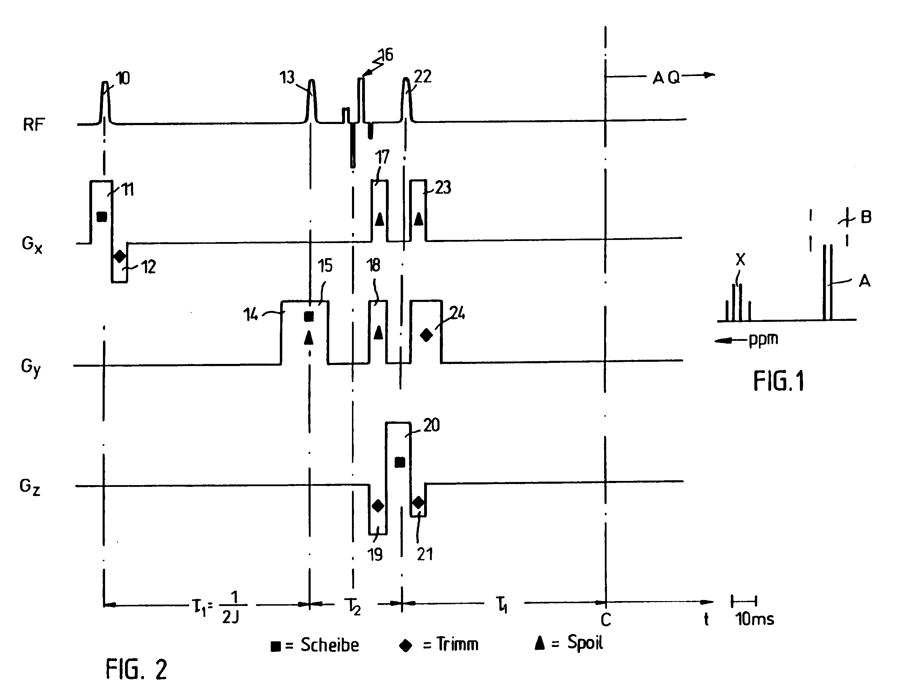

Fig. 1 zeigt in äußerst schematisierter Weise ein Kernresonanzspektrum von Lactat, einem System, bei dem eine J-Kopplung zwischen den Protonen der $CH_3$-Gruppe (A-Linie bei 1,35 ppm) und dem Proton der CH-Gruppe (X-Linie bei 4,1 ppm) besteht. Die A-Linie der $CH_3$-Gruppe des Lactats wird dabei von der sehr viel intensiveren B-Linie der $CH_2$-Gruppe des umgebenden Lipids überdeckt, weil biologische Proben oft eine viel größere Lipidkonzentration aufweisen.

Das erfindungsgemäße Verfahren soll nun die A-Linie durch geeignete Editierung aus dem überlagerten Spektrum herauspräparieren. Hierzu dient das in Fig. 2 gezeigte Impulsprogramm. Das Impulsprogramm dient zur Durchführung einer volumenselektiven Messung, wobei sich versteht, daß das erfindungsgemäße Verfahren nicht auf volumenselektive Messungen eingeschränkt ist.

Das Impulsprogramm der Fig. 2 zeigt in der obersten Zeile Hochfrequenz-Impulse, worunter man in der Kernresonanztechnik getastete Hochfrequenz-Signale mit definierter Hüllkontur versteht. Man unterscheidet dabei zwischen sogenannten "SoftImpulsen", d.h. Impulsen relativ langer Impulsdauer und relativ niedriger Amplitude und sogenannten "harten Impulsen" mit relativ kurzer Dauer und großer Amplitude. Außerdem unterscheidet man zwischen selektiven und nicht-selektiven Impulsen, je nachdem, ob die Hüllkurve der Impulse ein schmales oder ein breites Frequenzspektrum zur Folge hat.

In den drei mittleren Zeilen des Impulsdiagramms der Fig. 2 sind Gradienten-Magnetfeld-Impulse $G_x$, $G_y$ und $G_z$ für die drei Koordinatenrichtungen x, y und z aufgetragen. Die in Fig. 2 mit dem Symbol " ■ " gekennzeichneten Impulse sind dabei sogenannte "Scheibengradienten", d.h. zur Selektion einer räumlichen Scheibe dienende Gradienten-Impulse, während die mit dem Symbol " ♦ " gekennzeichneten Impulse sogenannte "Trimmgradienten" darstellen, d.h. den Scheibengradienten vorausgehende oder ihnen nachfolgende Gradienten, die zur Fokussierung der Magnetisierung dienen. Die mit dem Symbol " ▲ " gekennzeichneten Impulse stellen schließlich sogenannte "Spoilgradienten" dar, mit denen es möglich ist, gezielt in einer Koordinatenrichtung bestimmte Magnetisierungen zu dephasieren oder zu rephasieren und damit deren Magnetisierung als Signal zu löschen bzw. wieder aufleben zu lassen.

Es versteht sich, daß die Gradienten-Magnetfeld-Impulse geschwindigkeits- und beschleunigungskompensiert sein können, wie dies an sich bekannt ist, z.B. aus der US-Z "Journal of Magnetic Resonance", 77 (1988), Seite 596.

Bei dem erfindungsgemäßen Verfahren kann nun zunächst, bevor die Impulsfolge der Fig. 2 einsetzt, in an sich bekannter Weise ein sogenannter Hochfrequenz-Vorsättigungsimpuls oder ein entsprechender Dephasierungsgradient, oder beides, eingesetzt werden, um die Magnetisierung der X-Gruppe und möglicher weiterer störender Signale, z.B. die von Wasser, zu löschen, damit diese für das weitere Vorgehen vernachlässigt werden kann.

Das eigentliche erfindungsgemäße Verfahren beginnt indes mit einem ersten Hochfrequenz-Impuls, vorzugsweise einem 90°-Hochfrequenz-Impuls 10, der während der Wirkung eines ersten Scheibengradienten 11 mit nachfolgendem Trimmgradienten 12 in x-Richtung auf die Probe eingestrahlt wird.

Der erste 90°-Hochfrequenz-Impuls 10 ist ebenso wie die weiter unten noch zu erläuternden weiteren 90°-Hochfrequenz-Impulse ein sogenannter Softpuls, der beispielsweise eine Hüllkurve sinx/x aufweist und in Gegenwart eines Magnetfeldgradienten in x-, y- oder z-Richtung scheibenselektiv wirkt. Der erste 90°-Hochfrequenz-Impuls 10 wirkt ebenso wie die weiteren 90°-Hochfrequenz-Impulse, die weiter unten noch erläutert werden, nicht selektiv hinsichtlich der chemischen Verschiebung.

Die Pulswinkel der 90°-Hochfrequenz-Impulse sind relativ unkritisch. Prinzipiell muß der Pulswinkel nur größer als 0° sein. Beispielsweise kann der erste "90°"-Hochfrequenz-Impuls als sogenannter "ERNST"-Winkel eingestellt werden, der kleiner als 90° ist. Dieser Winkel erlaubt bei bildgebenden Messungen (Imaging) eine schnelle Bildfolge.

Es ist ferner möglich, den ersten 90°-Hochfrequenz-Impuls 10 durch eine zeitlich vorversetzte Impulsfolge aus einem 90°-Hochfrequenz-Impuls und einem für die A-Magnetisierung selektiven 180°-Hochfrequenz-Impuls zu ersetzen, um Störsignale, z.B. von Wasser, noch besser zu unterdrücken.

Infolge des ersten 90°-Hochfrequenz-Impulses 10 kippt die gesamte Magnetisierung der A- und X-Kerne in die x-y-Ebene, wobei dies für die X-Magnetisierung naturgemäß nur dann gilt, wenn diese nicht zuvor in der oben beschriebenen Weise gelöscht wurde.

Die Magnetisierung der A-Gruppe, d.h. z.B. die der Methylgruppe des Lactats ($A_3X$-System) evolviert nun unter dem Einfluß der J-Kopplung im nachfolgenden Zeitintervall $\tau_1$, wobei für ein $A_nX$-System in Abhängigkeit von der transversalen Relaxationszeit $T_2$ allgemein gilt:

$$\tau_1 = \frac{1}{\Pi J} \text{ arc cot } \left( \frac{1}{\Pi J T_2} \right)$$

Für diesen Ausdruck gilt somit: $\tau_1 \leqq 1/(2J)$ oder ein ungeradzahliges Vielfaches davon.

Für ein $A_nX_2$-System gilt entsprechend:

$$\tau_1 = \frac{1}{2 \Pi J} \text{ arc cot } \left( \frac{1}{2 \Pi J T_2} \right)$$

Es bildet sich nun eine Antiphasenmagnetisierung aus. Für Lactat beträgt J z.B. 7,35 Hz, so daß das Zeitintervall $\tau_1$ mit 68 ms eingestellt wird.

Nach Ablauf der Zeit $\tau_1$ wird nun ein zweiter 90°-Hochfrequenz-Impuls 13 auf die Probe eingestrahlt, während gleichzeitig in y-Richtung ein Scheibengradient 14 bzw. ein Trimmgradient 15 auf die Probe ausgeübt wird.

Der zweite 90°-Hochfrequenz-Impuls 13 bewirkt, daß die Antiphasenmagnetisierung der A-Gruppe, und nur diese, auf die X-Spins durch Polarisationstransfer übertragen wird, was aufgrund der J-Kopplung zwischen der A-Gruppe und der X-Gruppe (CH) bei bestimmter chemischer Verschiebung möglich ist, während die B-Magnetisierung mangels entsprechender Kopplung nicht transferiert werden kann. Ist jedoch eine vierte Gruppe Y von Kernen vorhanden, die nur mit der B-Gruppe gekoppelt ist, wird die (störende) B-Magnetisierung durch Polarisationstransfer auf die Y-Gruppe übertragen, wenn die A-Magnetisierung auf die X-Gruppe übertragen wird.

Die X-Spins befinden sich nun ebenfalls in Antiphase zueinander.

Durch den zweiten 90°-Hochfrequenz-Impuls 13 wird die Magnetisierung der A-Gruppe - allgemeiner ausgedrückt - zu etwa 1/2 durch Polarisationstransfer, zu 1/4 durch Doppelquantentransfer und zu einem weiteren 1/4 durch Nullquantentransfer (bei Experimenten mit heteronuklear gekoppelten Spinsystemen: durch Mehrquantentransfer) übertragen. Im Rahmen der in der vorliegenden Anmeldung beschriebenen Erfindung soll nur derjenige übertragene Anteil betrachtet werden, der durch Polarisationstransfer übertragen wird. Im Rahmen einer parallelen Anmeldung vom selben Tage und derselben Anmelderin WO-A- 90/13827 soll derjenige Anteil von 1/4 betrachtet werden, der im Wege des Doppelquanten- oder Mehrquantentransfers übertragen wird.

Nur die Antiphasen-X-Magnetisierung wird nun vorzugsweise über einen 180°-Hochfrequenz-Impuls 16 auf einen zeitlich zum zweiten 90°-Hochfrequenz-Impuls 13 symmetrischen Punkt abgebildet, der im zeitlichen Abstand $\tau_2$ zum zweiten 90°-Hochfrequenz-Impuls 13 liegt. Auch bei dem 180°-Hochfrequenz-Impuls muß der Winkel von 180° nicht exakt eingehalten werden.

Der 180°-Hochfrequenz-Impuls 16 ist selektiv für die X-Gruppe, d.h. selektiv in Bezug auf die chemische Verschiebung. Er wirkt somit, falls eine vierte Gruppe Y vorhanden ist, nicht auf die dorthin durch Polarisationstransfer übertragene B-Magnetisierung.

Durch den 180°-Hochfrequenz-Impuls 16 wird der Einfluß der J-Modulation auf die Magnetisierung der X-Gruppe wieder rückgängig gemacht.

Während dies geschieht, wird ein Spoilgradient 17 in x-Richtung sowie Trimm- und Scheibengradienten 14, 15, 18 in y-Richtung und eine Folge von Trimm- und Scheibengradienten 19, 20, in z-Richtung auf die Probe ausgeübt. Der Spoilgradient 17 bewirkt eine definierte Dephasierung, d.h. eine Kodierung der X-Magnetisierung.

Im zeitlichen Abstand $\tau_2$ zum zweiten 90°-Hochfrequenz-Impuls 13, d.h. symmetrisch zum vorzugsweise eingestrahlten 180°-Hochfrequenz-Impuls 16 wird ein dritter 90°-Hochfrequenz-Impuls 22 auf die Probe eingestrahlt, der für eine Rückpolarisation der X-Magnetisierung in den Bereich der A-Gruppe sorgt. Das Zeitintervall $\tau_2$ zwischen dem zweiten Hochfrequenz-Impuls 13 und dem dritten Hochfrequenz-Impuls 22 wird dabei so kurz wie möglich eingestellt.

Diese rücktransferierte Magnetisierung evolviert nun in dem anschließenden $\tau_1$-Intervall zu einer In-Phasen-Magnetisierung, die ab dem Zeitpunkt C, an dem ein Echomaximum auftritt, in einem Aufnahmeintervall AQ als freier Induktionsabfall (FID) mit bekannten Fourier-Verarbeitungsmethoden aufgenommen und dargestellt werden kann. Dabei wird vorzugsweise nur die "rechte" Seite des Echos, d.h. ab dem Zeitpunkt C, aufgenommen.

Zusätzlich wird symmetrisch zum dritten 90°-Hochfrequenz-Impuls 22 ein weiterer Spoilgradient 23 symmetrisch zum Spoilgradienten 17 in x-Richtung sowie ein Trimmgradient 24 in y-Richtung und ein Trimmgradient 21 in z-Richtung auf die Probe ausgeübt.

Auf diese Weise wird erreicht, daß die X-Magnetisierung durch die Spoilgradienten 17 definiert dephasiert, d.h. wieder dekodiert wird, womit deren durch die Hochfrequenz-Impulse 13 und 16 vorgegebene beliebige Phase bezüglich dem dritten 90°-Hochfrequenz-Impuls 22 ohne Einfluß ist und eine Scheibenselektion in z-Richtung ermöglicht.

Nach dem Polarisationsrücktransfer durch den dritten 90°-Hochfrequenz-Impuls 22 und der Rephasierung der A-Magnetisierung durch den zweiten Spoilgradienten 23 ist an dieser Stelle des Spektrums somit nur noch eine meßbare Magnetisierung der A-Gruppe vorhanden, die dann in der bekannten Weise ausgewertet werden kann, während ggf. noch auftretende stimulierte Echos durch den zweiten Spoilgradienten 23 unterdrückt werden.

Man erkennt aus Fig. 2 nämlich, daß die Gradientenimpulse asymmetrisch zu den 90°-Impulsen 13 und 22 wirken, so daß keine unerwünschte Refokussierung anderer ungekoppelter Spins erfolgen kann, weil dies durch die asymmetrische Anordnung der Gradientenimpulse in beiden $\tau_1$-Intervallen verhindert wird.

Man erkennt aus Fig. 2 ferner, daß der Einfluß der chemischen Verschiebung und von Magnetfeldinhomogenitäten auf die A-Magnetisierung während der Dauer des ersten $\tau_1$-Intervalls durch die beiden 90°-Impulse 13 und 22, die gedanklich als 180°-Impuls zusammengefaßt werden können, im zweiten $\tau_1$-Intervall wieder rückgängig gemacht werden.

Für die X-Magnetisierung geschieht dies in entsprechender Weise (einschließlich der J-Modulation) durch den für diese Gruppe selektiven 180°-Impuls 16 im Intervall $\tau_2$.

Die Wirkungsweise des in Fig. 2 gezeigten Impulsprogrammes wurde experimentell u.a. mit folgenden Versuchen verifiziert:

Fig. 3 zeigt schematisch eine Probe 30, bei der sich eine Kugel 31 von etwa 1 cm³ Volumen mit einer Mischung aus 50 % reinem Acetat und 50 % reinem Lactat in einer Umgebung 32 aus Wasser befindet.

Fig. 4 zeigt hierzu ein nach dem Stand der Technik aufgenommenes Spektrum mit einer Aufnahme, bei dem neben der Lactat-Linie bei etwa 1,35 ppm noch eine störende Acetat-Linie bei etwa 2,0 ppm auftritt. Die Messung wurde mit einer Impulsfolge ähnlich derjenigen durchgeführt, die in der US-Z "Journal of Magnetic Resonance", 72, 1987, Seite 379, beschrieben ist. Die Magnetfeldstärke betrug 4,7 T.

Fig. 5 zeigt demgegenüber eine Messung nach dem erfindungsgemäßen Verfahren mit einem Impulsprogramm nach Fig. 2, bei ansonsten unveränderten experimentellen Bedingungen, abgesehen von einem Skalierungsfaktor 2 bei der Signaldarstellung. Man erkennt aus Fig. 5 deutlich, daß das $CH_3$-Signal bei 1,35 ppm unter Berücksichtigung dieses Skalierungsfaktors etwa gleich hoch ist, wie beim Spektrum der Fig. 4. Die ungekoppelten Spins des Acetats sind hingegen praktisch verschwunden.

Fig. 6 zeigt eine Kontrollmessung, bei der die Volumenselektivität des erfindungsgemäßen Verfahrens überprüft wurde.

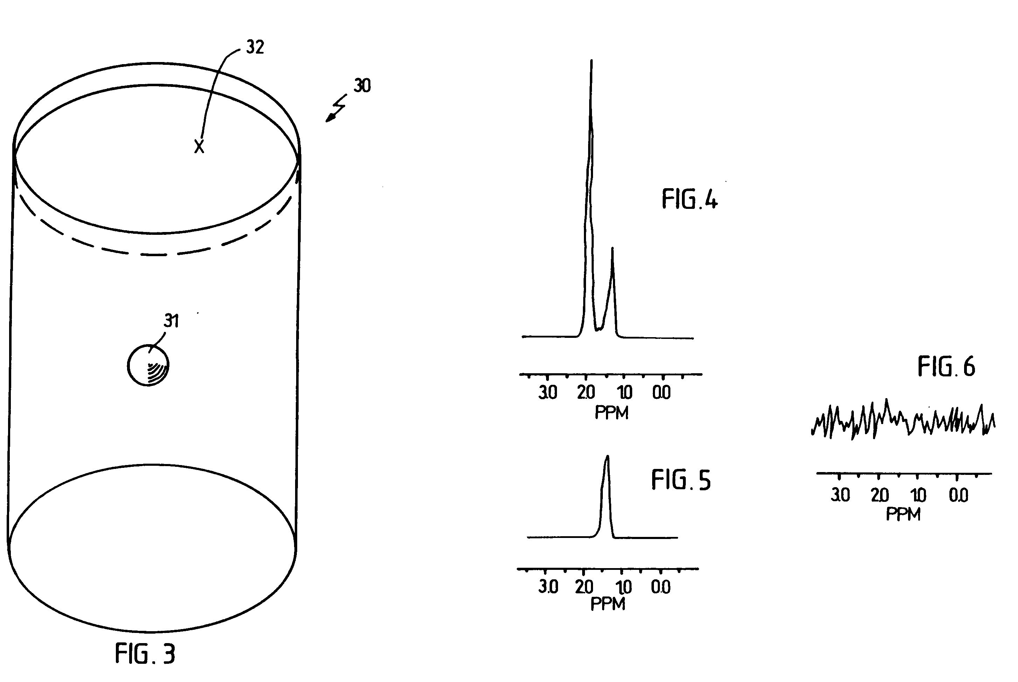

Bei der Messung der Fig. 6 wurde eine Probe mit einem räumlichen Aufbau gemäß Fig. 3 verwendet, jedoch bestand die Kugel 31 aus reinem Acetat während die Umgebung 32 aus reiner Milchsäure bestand.

Man erkennt aus Fig. 6 deutlich, daß die Messung selektiv arbeitet, weil lediglich der Volumenbereich der Kugel 31 gemessen wurde, bei der bei dem erfindungsgemäßen Verfahren die ungekoppelten Spins des Acetats unterdrückt werden, während kein $CH_3$-Signal der Milchsäure (Lactat) gemessen wurde, weil sich am Ort der Kugel 31, und nur dort, keine Milchsäure befindet.

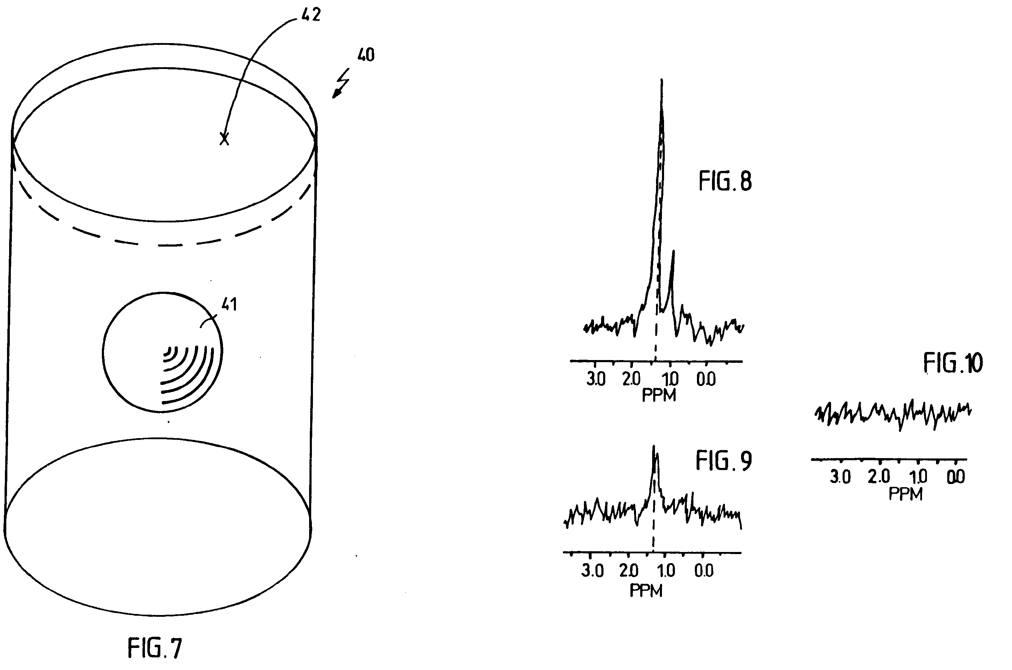

Bei einer weiteren Versuchsserie wurde eine Probe 40 gemäß Fig. 7 verwendet, bei der sich eine Kugel 41 in einer Umgebung 42 befand. Die Kugel 41 hatte mit 27 $cm^3$ ein wesentlich größeres Volumen als das der Kugel 31 bei der Probe 30 gemäß Fig. 3.

Zunächst bestand die Kugel 41 aus einer Emulsion aus 5 % Olivenöl (mit gekoppelten und ungekoppelten Lipiden) sowie 10 mMol Lactat.

Fig. 8 zeigt ein Spektrum, das in herkömmlicher Weise, mit einer Impulsfolge entsprechend der bei dem Spektrum der Fig. 4 verwendeten bei 2 T Magnetfeldstärke in einem Ganzkörpertomograph bei einer Aufnahme aufgenommen wurde, und man erkennt hier deutlich das starke Lipid-Signal ($CH_2$-Gruppe) bei etwa 1,4 ppm, welches das Lactat-Signal überdeckt. Bei etwa 0,9 ppm ist der zur $CH_2$-Gruppe gehörende Kopplungspartner, die $CH_3$-Gruppe, sichtbar.

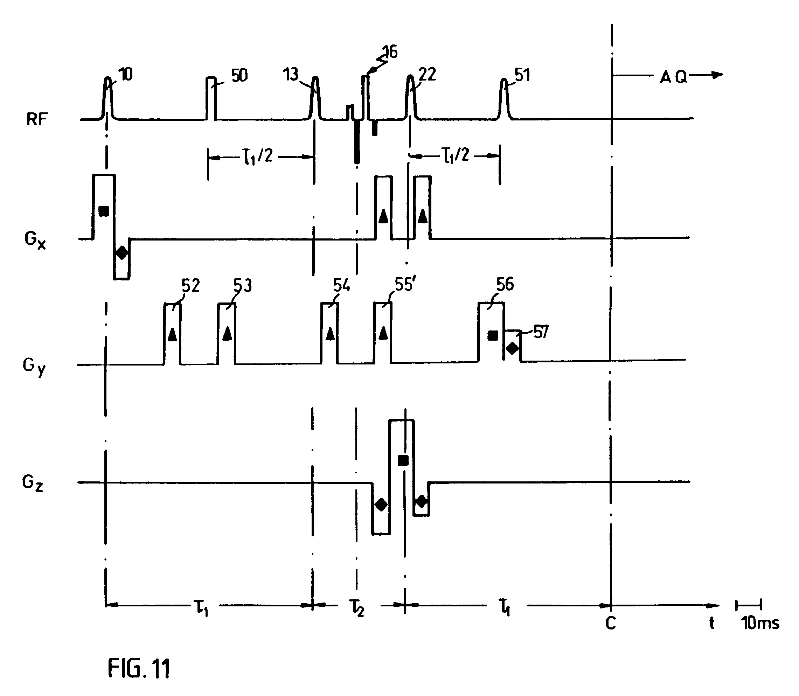

Fig. 9 zeigt demgegenüber wiederum eine Messung nach dem erfindungsgemäßen Verfahren mit 16 Akkumulationsaufnahmen, und es verbleibt lediglich das gewünschte Lactat-Signal, während das starke Lipid-Signal unterdrückt werden konnte. Dies beweist eine Kontrollmessung in Fig. 10, bei der die Kugel 41 nur mit 5 % Olivenöl-Emulsion gefüllt war, so daß kein Signal gemessen wurde.

Fig. 11 zeigt eine Variante des Pulsprogramms gemäß Fig. 2. Bei der in Fig. 11 dargestellten Variante wird jeweils ein 180°-Hochfrequenz-Impuls 50 bzw. 51 in der zeitlichen Mitte zwischen dem ersten 90°-Hochfrequenz-Impuls 10 und dem zweiten 90°-Hochfrequenz-Impuls 13 bzw. nach dem dritten 90°-Hochfrequenz-Impuls 22 eingestrahlt. Der zeitliche Abstand der 180°-Hochfrequenz-Impulse 50 bzw. 51 von den jeweils vorausgehenden 90°-Hochfrequenz-Impulsen 10 bzw. 22 beträgt daher jeweils $\tau_1/2$.

Bei den Magnetfeld-Gradienten-Impulsen werden lediglich die $G_y$-Gradienten verändert, und man erkennt in Fig. 11 vier Spoilgradienten 52, 53, 54, 55, die symmetrisch zum ersten 180°-Hochfrequenz-Impuls 50 bzw. symmetrisch zum 180°-Hochfrequenz-Impuls 16 eingestrahlt werden. Der y-Scheibengradient liegt als Scheibengradient 56 jetzt zeitgleich mit dem zweiten scheibenselektiven 180°-Hochfrequenz-Impuls 51 und wird wiederum von einem Trimmgradienten 57 gefolgt.

Mit dem Impulsprogramm der Fig. 11 ist eine Verdoppelung der Signalintensität gegenüber der in Fig. 2 möglich.

Die vorstehend beschriebenen Verfahren zur Messung von Kernresonanzspektren an homonuklear gekoppelten Spinsystemen unter Ausnutzung eines zyklischen Polarisationstransfers (CYCLPOT) beruhen auf der folgenden Überlegung:

Der reduzierte Gleichgewichtsdichteoperator in einem $A_nX$-System lautet in Hochtemperatur-Näherung:

$$\delta(O_-) = \sum_{k=1}^{n+1} I_{kz}$$

Dabei ist $I_1, I_2..., I_n$ der A-Gruppe zugeordnet, z.B. beim $A_3X$-System (Lactat) ist dies die $CH_3$-Gruppe und $I_{n+1}$ entspricht der X-Gruppe, z.B. beim $A_3X$-System (Lactat) ist dies die CH-Gruppe.

Nach dem ersten 90°-Hochfrequenz-Impuls 10 (x-Phase) gilt für den Gleichgewichtsdichteoperator:

$$\delta = -\sum_{k=1}^{n+1} I_{ky}$$

Nach dem ersten Evolutionsintervall $\tau_1 = 1/(2J)$ ergibt sich einschließlich der Dephasierungsgradienten, welche den Spins eine ortsabhängige Phase $\Phi$ aufprägen (diese sei sehr viel größer als die chemische Verschiebung, so daß diese vernachlässigbar ist):

$$\delta \quad = \sum_{k=1}^{n} \left[ 2 \ I_{kx} \ I_{(n+1)z} \ \cos \ \Phi_1 \ + \ 2 \ I_{ky} \ I_{(n+1)z} \ \sin \ \Phi_1 \right]$$

Kompliziertere zusätzlich auftretende Terme können dabei vernachlässigt werden, weil diese praktisch nicht beobachtbar sind, bzw. durch eine zusätzliche Vorsättigung der X-Gruppe (bzw. von Wasser) erst gar nicht auftreten.

Der zweite 90°-Hochfrequenz-Impuls 13, der eine y-Phase aber auch eine beliebige andere Phase haben kann, bewirkt den Polarisationstransfer, d.h. den Transfer der A-Magnetisierung auf die X-Magnetisierung:

$$\delta \quad = \sum_{k=1}^{n} \left[ - \ 2 \ I_{kz} \ I_{(n+1)x} \ \cos \ \Phi_1 \ + \ 2 \ I_{ky} \ I_{(n+1)x} \ \sin \ \Phi_1 \right]$$

Der erste Term entspricht einer X-Antiphasenmagnetisierung. Der zweite Term dieses Ausdrucks, der Mehrquantenkohärenzen entspricht, wird durch die folgenden Gradienten weggespoilt und kann daher für die nachfolgende Betrachtung weggelassen werden.

Der hinsichtlich der chemischen Verschiebung selektive 180°-Hochfrequenz-Impuls 16 refokussiert nur die Spins der X-Gruppe, also $I_{(n+1)x}$, so daß der Zustand, wie er nach dem zweiten 90°-Hochfrequenz-Impuls 13 herrschte, auf den Zustand kurz vor dem dritten 90°-Hochfrequenz-Impuls 22 abgebildet wird. Dieser dritte 90°-Hochfrequenz-Impuls 22 (y-Phase) bewirkt nun einen Polarisationsrücktransfer der X-Magnetisierung auf A-Magnetisierung:

$$\delta = \sum_{k=1}^{n} \left[ 2 \ I_{kx} \ I_{(n+1)z} \ \cos \ \Phi_1 \ \cos \ \Phi_2 \ + \ 2 \ I_{kx} \ I_{(n+1)y} \ \cos \ \Phi_1 \ \sin \ \Phi_2 \right]$$

$\Phi_2$ berücksichtigt die vom 180°-Hochfrequenz-Impuls 16 nicht refokussierte Dephasierung im $\tau_2$-Intervall. Der zweite Term entspricht Mehrquantenkohärenzen, die nicht zu beobachtbaren Signalen führen und deswegen weggelassen werden.

Im letzten $\tau_1$-Intervall (wobei weiter gilt: $\tau_1 = 1/(2J)$) wird die A-Antiphasenmagnetisierung in eine In-Phasen-Magnetisierung überführt. Gleichzeitig werden die Dephasierungen in den vorangegangenen Intervallen wieder rückgängig gemacht:

$$\delta \quad = \sum_{k=1}^{n} \ I_{ky} \ \left\{ \cos^2 \ \Phi_1 \ \cos^2 \ \Phi_2 \ + \ \sin \ \Phi_1 \ \cos \ \Phi_1 \ \sin \ \Phi_1 \ \cos \ \Phi_2 \right\}$$

$$- \ I_{kx} \ \left\{ \cos^2 \ \Phi_1 \ \sin \ \Phi_2 \ \cos \ \Phi_2 \ + \ \sin \ \Phi_1 \ \cos \ \Phi_1 \ \cos^2 \ \Phi_2 \right\}$$

Bei der Impulsfolge der Fig. 2 gilt:

$$\langle \delta \rangle = \frac{1}{\pi^2} \int_0^\pi \int_0^\pi \ldots \, d\Phi_1 \, d\Phi_2$$

mit

$$\langle \delta \rangle = \frac{1}{4} I_{ky}$$

woraus folgt, daß der Signalverlust etwa 1/4 gegenüber einer fiktiven Messung mit freiem Induktionsabfall (FID) eintritt.

Bei der Impulsfolge gemäß Fig. 11 muß $\Phi_1 = 0$ sein, da die Phase des zweiten 90°-Hochfrequenz-Impulses 13 gegenüber derjenigen des ersten 90°-Hochfrequenz-Impulses 10 um 90° gedreht ist. Da die 180°-Hochfrequenz-Impulse 50 und 51 die chemische Verschiebung und die Gradienten refokussieren, wird über $\Phi_1$ nicht gemittelt. Es folgt:

$$\langle \delta \rangle = \frac{1}{\pi} \int_0^\pi \ldots \, d\Phi_2 \qquad ;$$

$$\Phi_1 = 0$$

mit

$$\langle \delta \rangle = \frac{1}{2} I_{ky}$$

woraus folgt, daß nur ein Signalverlust von 1/2 gegenüber einer fiktiven FID-Messung eintritt.

Eine entsprechende Betrachtung läßt sich z.B. auch für Spins mit $I > \frac{1}{2}$ durchführen.

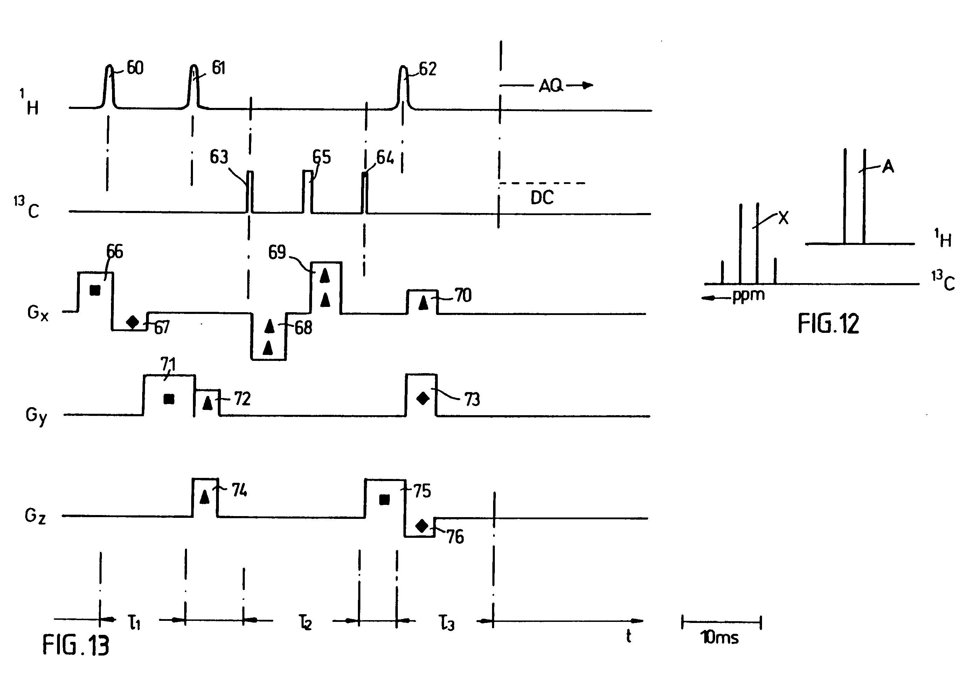

Fig. 12 zeigt in einer Darstellung ähnlich Fig. 1 ein heteronuklear gekoppeltes System. Ein solches heteronuklear gekoppeltes Spinsystem kann z.B. das Spinsystem von Glukose, Glykogen bzw. $^{13}C$ angereicherten natürlich vorkommenden Substanzen oder Medikamenten sein, die für die biomedizinische Forschung von großem Interesse sind. Diese Systeme erlauben nämlich Rückschlüsse auf den Metabolismus im organischen Gewebe.

Bei den vorstehend erläuterten Varianten des erfindungsgemäßen Verfahrens in ihrer Anwendung bei homonuklear gekoppelten Systemen spielte sich der Polarisationstransfer und der Polarisationsrücktransfer innerhalb derselben Kernart, nämlich typischerweise bei Protonen ab.

Im Gegensatz hierzu finden die nachstehend erläuterten Varianten des erfindungsgemäßen Verfahrens Anwendung bei heteronuklear gekoppelten Systemen, bei denen Kopplungen zwischen unterschiedlichen Kernarten, dargestellt am Beispiel von Protonen ($^1H$) und $^{13}C$ bestehen. Die Anregung und der Signalempfang auf Protonenseite liefert dabei eine maximale Signalintensität. Dabei müssen allerdings große Signalanteile von ungekoppelten Spins, wie z.B. Wasser, Fett oder bei natürlichem $^{13}C$-Vorkommen (1 %) die Hauptlinien, vollständig unterdrückt werden, um die J-gekoppelten $^{13}C$-Satelliten indirekt nachweisen zu können.

Mit der anhand der Fig. 13 beschriebenen Impulsfolge können heteronuklear gekoppelte Spinsysteme auf der Protonenseite editiert, d.h. herauspräpariert werden, während gleichzeitig die störenden gekoppelten und ungekoppelten Signale vollständig unterdrückt werden.

Die Darstellung der Fig. 13 entspricht dabei hinsichtlich der verwendeten Symbole vollständig derjenigen der Fig. 2 und 11, lediglich auf der Hochfrequenzseite wurden zwei Achsen $^1H$ und $^{13}C$ für die beiden Kernarten eingesetzt.

Die Betrachtung der Fig. 12 und 13 soll am Beispiel der $^{13}C$-angereicherten Testsubstanz Methanol, einem $A_3X$-System, vorgenommen werden, bei dem eine J-Kopplung zwischen den Protonen der $CH_3$-Gruppe (A-Linie bei 3 ppm) und dem $^{13}C$-Kern (X-Linie bei 50 ppm) besteht. Die heteronukleare J-Kopplung der biologisch interessanten Substanzen beträgt etwa, wie bei Methanol, J = 141 Hz, was nach der bereits weiter oben erläuterten Formel für das Zeitintervall $\tau_1$ einen Wert von $\tau_1 = 10,7$ ms für den Fall $\tau_1 = 3/(2J)$ ergibt.

Wie bereits erwähnt, wird bei dieser Verfahrensvariante das Signal, nämlich das A-Dublett auf der Protonenseite detektiert, wo aufgrund der dort vorhandenen drei Protonen zusätzlich eine höhere Signalintensität auftritt als dies auf der $^{13}$C-Seite bei dem dort nur vorhandenen einen Kern der Fall wäre.

In Fig. 13 ist erkennbar, daß auf der Protonenseite wiederum drei Hochfrequenz-Impulse, nämlich drei 90°-Hochfrequenz-Impulse 60, 61, 62 eingestrahlt werden. Da wir es hier mit einem heteronuklearen System zu tun haben, muß sowohl die A- wie auch die X-Magnetisierung "breitbandig" angeregt werden. Ein erster Polarisationstransfer findet daher über den zweiten 90°-Hochfrequenz-Impuls 61 sowie einen auf $^{13}$C-Seite eingestrahlten selektiven 90°-Hochfrequenz-Impuls 63 statt, während der anschließende Polarisationsrücktransfer über einen weiteren $^{13}$C-seitigen selektiven 90°-Hochfrequenz-Impuls 64 und den dritten protonenseitigen 90°-Hochfrequenz-Impuls 62 stattfindet.

Bei der in Fig. 13 gezeigten Variante wird auf $^{13}$C-Seite in der zeitlichen Mitte zwischen den 90°-Hochfrequenz-Impulsen 63 und 64 ein 180°-Hochfrequenz-Impuls 65 selektiv auf $^{13}$C eingestrahlt, der die X-Magnetisierung refokussiert. Wie bereits weiter oben anhand der homonuklear gekoppelten Spinsysteme erläutert, werden auch bei der Impulsfolge gemäß Fig. 13 die $^{13}$C-Spins im $\tau_2$-Intervall dephasiert und die Protonen im nachfolgenden Zeitintervall $\tau_3$ wieder rephasiert. Das nachfolgende Zeitintervall $\tau_3$ ist üblicherweise zeitlich ebenso lang wie das erste Zeitintervall $\tau_1$.

Die Erzeugung stimulierter Echos ungekoppelter Protonen wird durch asymmetrische Gradienten in beiden Protonenintervallen verhindert.

Fig. 13 zeigt in x-Richtung, daß zum Zeitpunkt des ersten 90°-Hochfrequenz-Impulses 60 auf Protonenseite zunächst ein Scheibengradient 66 mit nachfolgendem Trimmgradienten 67 auf die Probe ausgeübt wird. Im $^{13}$C-Intervall der Länge $\tau_2$ werden zwei Spoilgradienten 68, 69 zeitlich symmetrisch zum 180°-Hochfrequenz-Impuls 65 auf die Probe ausgeübt, wobei die beiden Spoilgradienten 68, 69 ungleichpolig sind. Aufgrund des viermal kleineren gyromagnetischen Verhältnisses von $^{13}$C gegenüber Protonen müssen die Gradienten im $\tau_2$-Intervall viermal größer sein, was durch die vier Symbole " ▲ " angedeutet ist. Ein weiterer Spoilgradient 70 ist zeitlich nach dem dritten 90°-Hochfrequenz-Impuls 62 auf Protonenseite in x-Richtung plaziert.

In y-Richtung wird zum Zeitpunkt des zweiten 90°-Hochfrequenz-Impulses 61 auf Protonenseite zunächst ein Scheibengradient 71 und dann ein nachfolgender Spoilgradient 72 geschaltet, während zeitgleich zum Spoilgradienten 70 in x-Richtung in y-Richtung ein Trimmgradient 73 vorgesehen ist.

In z-Richtung liegt ein Spoilgradient 74 zeitgleich zum Spoilgradienten 72 in y-Richtung, während zum Zeitpunkt des dritten 90°-Hochfrequenz-Impulses 62 auf Protonenseite zunächst ein Scheibengradient 75 und dann ein nachfolgender Trimmgradient 76 in z-Richtung geschaltet wird.

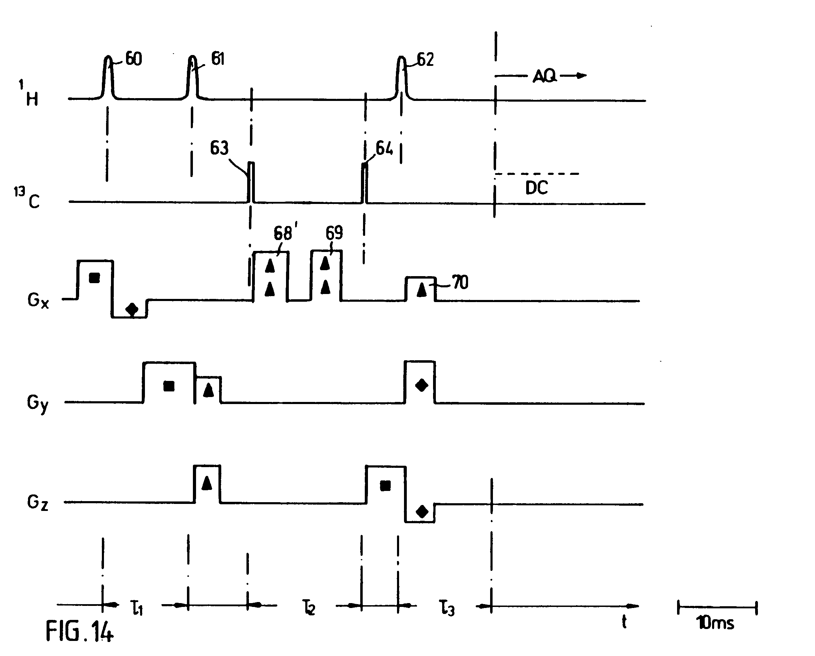

Die Impulsfolge der Fig. 14 unterscheidet sich nur geringfügig von derjenigen der Fig. 13. Man erkennt in Fig. 14, daß im $^{13}$C-Zeitintervall $\tau_2$ der 180°-Hochfrequenz-Impuls 65 auf der $^{13}$C-Seite fehlt. Demgegenüber sind in x-Richtung jetzt beide Dephasierungs-Spoilgradienten 68' und 69 gleichpolig geschaltet. Da der zum Refokussieren vorgesehene 180°-Hochfrequenz-Impuls 65 fehlt, muß für eine maximale X-Antiphasenmagnetisierung bei dem zweiten 90°-Hochfrequenz-Impuls 64 auf $^{13}$C-Seite die Intervall-Länge $\tau_2$ mit n/J eingestellt werden, wobei in diesem Fall aus Zeitgründen n = 2 gewählt wurde.

Grundsätzlich wäre es möglich, eine Impulsfolge ohne 180°-Refokussierungsimpuls auch bei Impulsfolgen einzusetzen, die für homonuklear gekoppelte Spinsysteme verwendet werden sollen, beispielsweise für die Impulsfolgen der Fig. 2 und 11. Allerdings würde dann das mittlere Zeitintervall $\tau_2$ bei jenen Impulsfolgen zu lang werden, und der damit verbundene Verlust an Signalintensität infolge transversaler Relaxation würde zu groß, und es wäre dann auch keine Unterdrückung ungewünschter gekoppelter Protonen mehr möglich.

Aufgrund von Magnetfeldinhomogenitäten, die bei der Impulsfolge gemäß Fig. 14 durch den fehlenden 180°-Hochfrequenz-Impuls nicht mehr refokussiert werden, muß das dritte Zeitintervall $\tau_3$ gleich $\tau_1 + \tau_2/4$ bzw. $= \tau_1 + n/(4J)$ betragen. Für n = 2 ergibt sich eine Antiphasenmagnetisierung mit guter Auflösung, da J groß ist. Bei guter Magnetfeldhomogenität kann auch $\tau_1 = \tau_3$ gewählt werden, was wieder zu einer detektierbaren In-Phasen-Magnetisierung führen würde.

Der Kopplungspartner unerwünschter gekoppelter Spinsysteme, eine beliebige andere X-Magnetisierung, wird bereits im $\tau_2$-Intervall weggespoilt, sobald einer oder mehrere $^{13}$C-Impulse nur auf eine bestimmte X-Magnetisierung hinsichtlich deren chemischer Verschiebung selektiv wirken. Damit wird die zugehörige beliebige A-Magnetisierung ebenfalls unterdrückt.

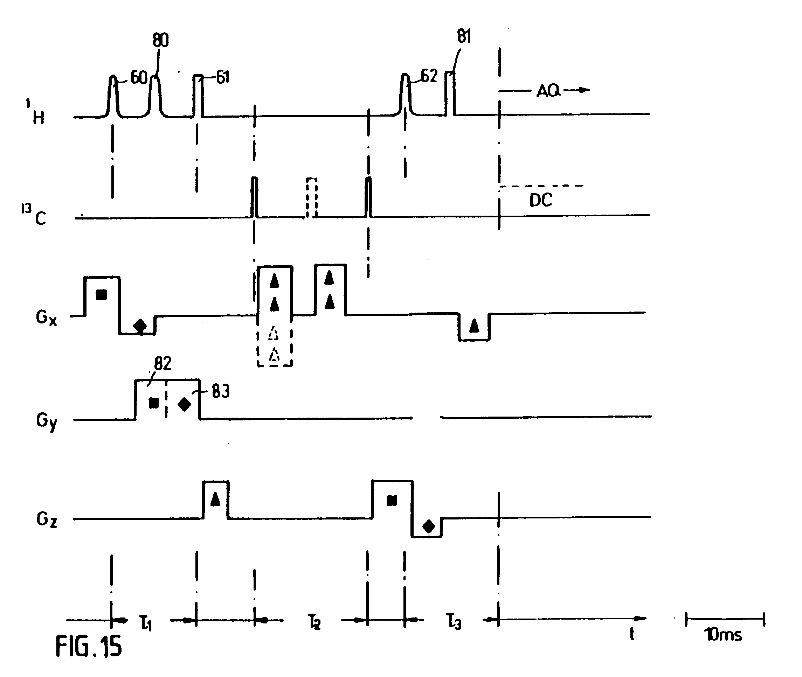

Fig. 15 zeigt schließlich eine Variante der Impulsfolgen der Fig. 13 und 14, bei der, in analoger Form zur Abwandlung der Impulsfolge gemäß Fig. 11 zu derjenigen der Fig. 2, zwei 180°-Hochfrequenz-Impulse 80 (scheibenselektiv) bzw. 81 zwischen die beiden ersten 90°-Hochfrequenz-Impulse 60, 61 bzw. nach den dritten 90°-Hochfrequenz-Impulsen 62 geschaltet werden, um eine Signalverstärkung um den Faktor 2 gegenüber der Impulsfolge in Fig. 13 bzw. 14 zu erreichen.

In Fig. 15 ist sowohl in der $^{13}$C-Achse wie in der x-Gradienten-Achse mit gestrichelten Linien angedeutet, daß dies für die Fälle beider Impulsfolgen nach Fig. 13 oder Fig. 14 möglich ist.

Man erkennt in Fig. 15 ferner, daß auch hier lediglich eine geringfügige Modifizierung der Gradienten in y-Richtung möglich ist, wie mit einem Scheibengradienten 82 und einem nachfolgenden Trimmgradienten 83 in y-Richtung eingezeichnet ist.

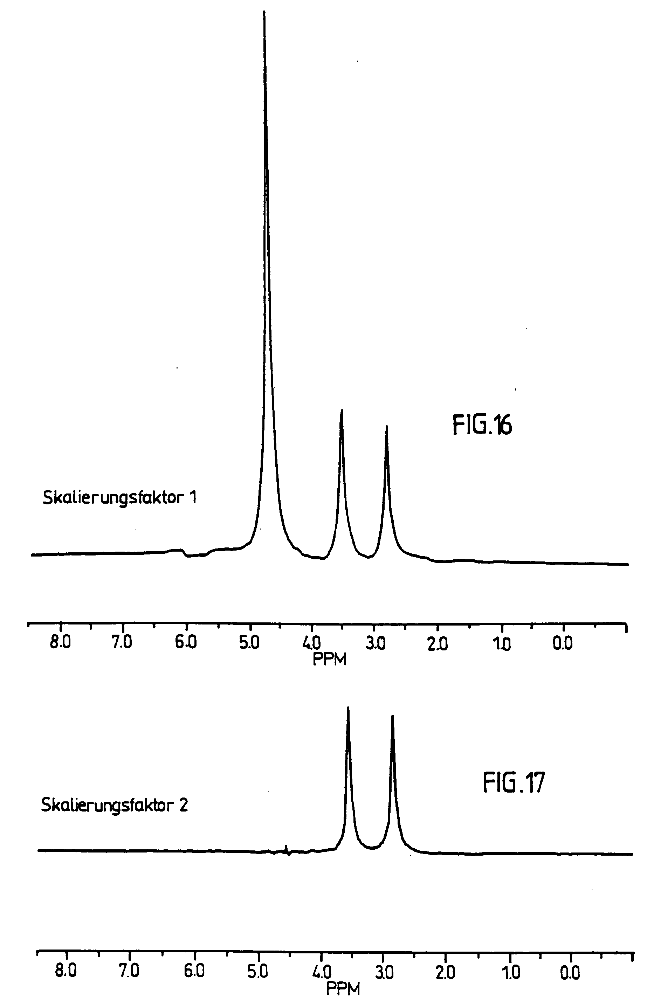

Fig. 16 zeigt ein Kernresonanzspektrum, bei dem eine Probe nach Art der Fig. 3 verwendet wurde, bei der eine von Wasser umgebene Kugel eines Volumens von einem Kubikzentimeter mit mit $^{13}$C angereichertem Methanol befüllt war. Das Kernresonanzspektrum der Fig. 16 ist mit einer nicht-editierenden Drei-Puls-Sequenz nach dem Stand der Technik bei einer Magnetfeldstärke von 4,7 T bei einem Durchlauf aufgenommen.

Demgegenüber zeigt Fig. 17 ein Kernresonanzspektrum, das mit einer Impulsfolge gemäß Fig. 13 aufgenommen wurde. Man erkennt, daß das $CH_3$-Signal bei 3 ppm (bei doppeltem Skalierungsfaktor) etwa gleich hoch ist wie das in Fig. 16, die ungekoppelten Spins bei 4,7 ppm sind jedoch praktisch verschwunden.

**Patentansprüche**

1. Verfahren zur Aufnahme von Kernresonanzspektren von Proben (30, 40) mit mindestens drei Gruppen (A, B, X) von Kernen derselben Kernart, von denen eine erste Gruppe (A) mit einer zweiten Gruppe (X) gekoppelt ist, während eine dritte Gruppe (B) mit der zweiten Gruppe (X) ungekoppelt ist, jedoch eine chemische Verschiebung aufweist, die nur mit derjenigen der ersten Gruppe (A) im wesentlichen übereinstimmt, wobei zur alleinigen Darstellung des Signals der ersten Gruppe (A) das Signal der dritten Gruppe (B) unterdrückt wird, dadurch gekennzeichnet,
   - daß eine Impulsfolge von drei Hochfrequenz-Impulsen, vorzugsweise 90°-Hochfrequenz-Impulsen (10, 13, 22) auf die Probe (30; 40) eingestrahlt wird,
   - daß der zweite Hochfrequenz-Impuls (13) derart eingestellt wird, daß die Magnetisierung der Kerne der ersten Gruppe (A) mittels Polarisationstransfer auf die Kerne der zweiten Gruppe (X) übertragen wird,
   - daß im Zeitintervall ($\tau_2$) zwischen dem zweiten Hochfrequenz-Impuls (13) und dem dritten Hochfrequenz-Impuls (22) ein für die Kerne der zweiten Gruppe (X) dephasierender, erster Gradienten-Magnetfeld-Impuls (17) auf die Probe (30; 40) ausgeübt wird,
   - daß der dritte Hochfrequenz-Impuls (22) derart eingestellt wird, daß die Magnetisierung der Kerne der zweiten Gruppe (X) mittels Polarisationsrücktransfer wieder auf die Kerne der ersten Gruppe (A) übertragen wird, und
   - daß sodann ein für die Kerne der ersten Gruppe (A) rephasierender, zweiter Gradienten-Magnetfeld-Impuls (17, 23) auf die Probe (30, 40) ausgeübt wird.

2. Verfahren nach Anspruch 1, dadurch gekennzeichnet, daß die Probe (30; 40) eine Lactat-Probe ist.

3. Verfahren zur Aufnahme von Kernresonanzspektren von Proben mit mindestens drei Gruppen (A, B, X) von Kernen, von denen eine erste Gruppe (A) einer ersten Kernart mit einer zweiten Gruppe (X) einer zweiten Kernart gekoppelt ist, während eine dritte Gruppe (B) der ersten Kernart mit der zweiten Gruppe (X) ungekoppelt ist, jedoch eine chemische Verschiebung aufweist, die nur mit derjenigen der ersten Gruppe (A) im wesentlichen übereinstimmt, wobei zur alleinigen Darstellung des Signals der ersten Gruppe (A) das Signal der dritten Gruppe (B) unterdrückt wird, dadurch gekennzeichnet,
   - daß eine Impulsfolge von fünf Hochfrequenz-Impulsen, vorzugsweise 90°-Hochfrequenz-Impulsen (60 bis 64) auf die Probe eingestrahlt wird,
   - daß der zweite Hochfrequenz-Impuls (61) und ein dritter Hochfrequenz-Impuls (63) derart eingestellt werden, daß die Magnetisierung der Kerne der der ersten Kernart angehörenden ersten Gruppe (A) mittels Polarisationstransfer auf die Kerne der der zweiten Kernart angehörenden zweiten Gruppe (X) übertragen wird,
   - daß im Zeitintervall ($\tau_2$) zwischen dem dritten Hochfrequenz-Impuls (63) und dem vierten Hochfrequenz-Impuls (64) mindestens ein für die Kerne der zweiten Gruppe (X) dephasierender, erster Gradienten-Magnetfeld-Impuls (68, 69) auf die Probe ausgeübt wird,
   - daß ein vierter Hochfrequenz-Impuls (64) und ein fünfter Hochfrequenz-Impuls (62) derart eingestellt werden, daß die Magnetisierung der Kerne der zweiten Gruppe (X) mittels Polarisationsrücktransfer wieder auf die Kerne der ersten Gruppe (A) übertragen wird, und
   - daß sodann ein für die Kerne der ersten Gruppe (A) rephasierender, zweiter Gradienten-Magnetfeld-Impuls (70) auf die Probe ausgeübt wird.

4. Verfahren zur Aufnahme von Spinresonanzspektren von Proben mit mindestens drei Gruppen (A, B, X) von Spins, von denen eine erste Gruppe (A) mit einer zweiten Gruppe (X) gekoppelt ist, während eine dritte Gruppe (B) mit der zweiten Gruppe (X) ungekoppelt ist, jedoch ein Signal mit einer spektralen Lage aufweist, die nur mit derjenigen der ersten Gruppe (A) im wesentlichen übereinstimmt, wobei zur alleinigen Darstellung des Signals der ersten Gruppe (A) das Signal der dritten Gruppe (B) unterdrückt wird, dadurch gekennzeichnet,

- daß eine Impulsfolge von mindestens drei Hochfrequenz-Impulsen, vorzugsweise 90°-Hochfrequenzlmpulsen auf die Probe eingestrahlt wird,
- daß mindestens der zweite Hochfrequenz-Impuls derart eingestellt wird, daß die Magnetisierung der Spins der ersten Gruppe (A) mittels Polarisationstransfer auf die Spins der zweiten Gruppe (X) übertragen wird,
- daß nach dem zweiten Hochfrequenz-Impuls mindestens ein für die Spins der zweiten Gruppe (X) dephasierender, erster Gradienten-Magnetfeld-Impuls auf die Probe ausgeübt wird,
- daß mindestens ein weiterer der Hochfrequenz-Impulse derart eingestellt wird, daß die Magnetisierung der Spins der zweiten Gruppe (X) alsdann mittels Polarisationsrücktransfer wieder auf die Spins der ersten Gruppe (A) übertragen wird und
- daß schließlich ein für die Spins der ersten Gruppe (A) rephasierender, zweiter Gradienten-Magnetfeld-Impuls auf die Probe ausgeübt wird.

5. Verfahren nach einem oder mehreren der Ansprüche 1 bis 4, dadurch gekennzeichnet, daß in an sich bekannter Weise zur volumenselektiven Darstellung die Probe (30; 40) einer Folge von Gradienten-Magnetfeld-Impulsen (11, 12, 14, 15, 17, 18, 19, 20, 21, 23, 24; 66 bis 76) unterschiedlicher Koordinatenrichtung (x, y, z) ausgesetzt wird, und daß mindestens drei der Hochfrequenz-Impulse (10, 13, 22; 60, 61, 62) scheibenselektiv eingestellt werden.

6. Verfahren nach einem oder mehreren der Ansprüche 1 bis 5, dadurch gekennzeichnet, daß nach dem den Polarisationstransfer bewirkenden Hochfrequenz-Impuls (13; 63) ein hinsichtlich der chemischen Verschiebung für die Kerne bzw. Spins der zweiten Gruppe (X) selektiver, weiterer Hochfrequenz-Impuls, vorzugsweise ein 180°-Hochfrequenz-Impuls (16; 65) eingestrahlt wird.

7. Verfahren nach einem oder mehreren der Ansprüche 1 bis 6, dadurch gekennzeichnet, daß vor dem Einstrahlen des ersten Hochfrequenz-Impulses (10; 60) ein für die Kerne bzw. Spins der zweiten Gruppe (X) sowie für ungekoppelte Kerne bzw. Spins selektiver Hochfrequenz-Vorsättigungs-Impuls und danach ein für die Kerne bzw. Spins der zweiten Gruppe (X) selektiver dephasierender Gradienten-Magnetfeld-Impuls auf die Probe (30; 40) eingestrahlt wird.

8. Verfahren nach einem oder mehreren der Ansprüche 1 bis 7, dadurch gekennzeichnet, daß der erste und der zweite Gradienten-Magnetfeld-Impuls (17, 23; 68/69, 70) in der Zeitachse (t) relativ zu den Hochfrequenzlmpulsen (13, 22; 61, 62) derart positioniert werden, daß keine stimulierten Echos ungekoppelter Spins erzeugt werden.

9. Verfahren nach einem oder mehreren der Ansprüche 1 bis 8, dadurch gekennzeichnet, daß in der zeitlichen Mitte zwischen dem ersten (10; 60) und dem den Polarisationstransfer bewirkenden Hochfrequenz-Impuls (13; 61) sowie nach dem den Polarisationsrücktransfer bewirkenden Hochfrequenz-Impuls (22; 62) jeweils ein 180°-Impuls (50, 51; 80, 81) auf die Probe (30; 40) eingestrahlt wird.

10. Verfahren nach einem oder mehreren der Ansprüche 1 bis 9, dadurch gekennzeichnet, daß das Zeitintervall ($\tau_1$) zwischen dem ersten Hochfrequenz-Impuls (10; 60) und dem zweiten Hochfrequenz-Impuls (13; 61) gleich einem ungeradzahligen Vielfachen des Kehrwertes des zweifachen der Kopplungskonstanten (J) zwischen der ersten Gruppe (A) und der zweiten Gruppe (X) bemessen wird.

11. Verfahren nach einem oder mehreren der Ansprüche 1 bis 9, dadurch gekennzeichnet, daß für ein $A_nX$-System das Zeitintervall ($\tau_1$) zwischen dem ersten Hochfrequenz-Impuls (10; 60) und dem zweiten Hochfrequenz-Impuls (13; 61) nach der Formel

$$\tau_1 = \frac{1}{\Pi J} \text{ arc cot } \frac{1}{\Pi J T_2}$$

bemessen wird, wobei J die Kopplungskonstante zwischen der ersten Gruppe (A) und der zweiten Gruppe (X) und $T_2$ die transversale Relaxationszeit ist.

12. Verfahren nach einem oder mehreren der Ansprüche 1 bis 9, dadurch gekennzeichnet, daß für ein $A_n X_2$-System das Zeitintervall ($\tau_1$) zwischen dem ersten Hochfrequenz-Impuls (10; 60) und dem zweiten Hochfrequenz-Impuls (13; 61) nach der Formel

$$\tau_1 = \frac{1}{2\,\Pi\,J} \; \text{arc cot} \; \frac{1}{2\,\Pi\,J\,T_2}$$

bemessen wird, wobei J die Kopplungskonstante zwischen der ersten Gruppe (A) und der zweiten Gruppe (X) und $T_2$ die transversale Relaxationszeit ist.

13. Verfahren nach einem oder mehreren der Ansprüche 3 bis 12, dadurch gekennzeichnet, daß das Zeitintervall ($\tau_2$) zwischen dem dritten Hochfrequenz-Impuls (63) und dem vierten Hochfrequenz-Impuls (64) gleich einem ganzzahligen Vielfachen der Kopplungskonstante (J) zwischen der ersten Gruppe (A) und der zweiten Gruppe (X) ist.

14. Verfahren nach einem oder mehreren der Ansprüche 5 bis 13, dadurch gekennzeichnet, daß in an sich bekannter Weise für eine bildgebende Darstellung eine volumenselektive Messung einer Mehrzahl von Bereichen der Probe (30; 40) durchgeführt wird.

**Claims**

1. Method for recording nuclear resonance spectra of test samples (30, 40) having at least three groups (A, B, X) of nuclei of the same kind, the first group (A) being coupled to a second group (X), while a third group (B) is uncoupled relative to the second group (X) but has a chemical shift which is substantially identical only to that of the first group (A), the method comprising the step of suppressing the signal of the third group (B) for the purpose of obtaining an isolated image of the signal of the first group (A), **wherein**
   - a pulse sequence of three r.f. pulses (10, 13, 22), preferably 90° r.f. pulses, are irradiated upon the said sample (30; 40),
   - the said second r.f. pulse (13) is applied in such a way that the magnetization of the nuclei of the first group (A) is transferred to the nuclei of the second group (X) by polarization transfer,
   - a first magnetic gradient field pulse (17), with dephasing effect for the nuclei of the said second group (X), is exerted upon the said sample (30; 40) in the time interval ($\tau_2$) between the second r.f. pulse (13) and the third r.f. pulse (22),
   - the third r.f. pulse (22) is adjusted in such a way that the magnetization of the nuclei of the said second group (X) is retransferred to the nuclei of the said first group (A) by polarization re-transfer; and
   - thereafter a second magnetic gradient field pulse (17, 23), being rephasing for the nuclei of the first group (A), is exerted upon the said sample (30, 40).

2. Method according to claim 1, **wherein** the said sample (30; 40) is a lactate sample.

3. Method for recording nuclear resonance spectra of samples having at least three groups (A, B, X) of nuclei, a first group (A) of a first kind of nuclei being coupled to a second group (X) of a second kind of nuclei, while a third group (B) of the first kind of nuclei is uncoupled relative to the second group (B), but has a chemical shift which is substantially identical only to that of the first group (A), the method comprising the step of suppressing the signal of the said third group (B) for the purpose of obtaining an isolated image of the signal of the said first group (A), **wherein**
   - a pulse sequence of five r.f. pulses (60 to 64), preferably 90° r.f. pulses, are irradiated upon the said sample,
   - the second r.f. pulse (61) and a third r.f. pulse (63) are adjusted in such a way that the magnetization of the nuclei of the said first group (A) belonging to the first kind of nuclei is transferred by polarization transfer to the nuclei of the said second group (X) belonging to the second kind of nuclei
   - at least one first magnetic gradient field pulse (68, 69), with dephasing effect for the nuclei of the said second group (X), is exerted upon the said sample in the time interval ($\tau_2$) between the said third r.f. pulse (63) and the said fourth r.f. pulse (64),
   - a fourth r.f. pulse (64) and a fifth r.f. pulse (62) are adjusted in such a way that the magnetization of the nuclei of the said second group (X) is retransferred to the nuclei of the said first group (A) by polarization re-transfer; and
   - thereafter a second magnetic gradient field pulse (70), being rephasing for the nuclei of the said first group (A), is exerted upon the said sample.

4. Method for recording spin resonance spectra of test samples having at least three groups (A, B, X) of spins, a first group (A) of them being coupled to a second group (X), while a third group (B) is uncoupled relative to the said second group (X) but provides a signal having a spectral position substantially identical only to that of the said first group (A), the method comprising the step of suppressing the signal of the said third group (B) for the purpose of obtaining an isolated image of the signal of the said first group (A), **wherein**

- a pulse sequence of at least three r.f. pulses, preferably 90° r.f. pulses, are irradiated upon the said sample,
- at least the second r.f. pulse is applied in such a way that the magnetization of the spins of the said first group (A) is transferred to the spins of the said second group (X) by polarization transfer,
- at least one first magnetic gradient field pulse, with dephasing effect for the spins of the said second group (X), is exerted upon the said sample following the said second r.f. pulse,
- at least another one of the r.f. pulses is adjusted in such a way that the magnetization of the spins of the said second group (X) is retransferred to the spins of the said first group (A) by polarization re-transfer; and
- finally a second magnetic gradient field pulse, being rephasing for the spins of the said first group (A), is exerted upon the said sample.

5. Method according to one or more of claims 1 to 4, **wherein** for volume-selective imaging, the said sample (30; 40) is exposed in a conventional manner to a sequence of magnetic gradient field pulses (11, 12, 14, 15, 17, 18, 19, 20, 21, 23, 24; 66 to 76) of different coordinate directions (x, y, z), and at least three of the said r.f. pulses (10, 13, 22; 60, 61, 62) are adjusted in a disc-selective manner.

6. Method according to one or more of claims 1 to 5, **wherein** another r.f. pulse, being selective for the nuclei of the said second group (X) with respect to the chemical shift, preferably a 180° r.f. pulse (16; 65), is irradiated after the said r.f. pulse (13; 63) effecting the polarization transfer.

7. Method according to one or more of claims 1 to 6, **wherein** prior to irradiating the said first 90° r.f. pulse (10; 60), one exposes the said sample (30; 40) to a r.f. pre-saturating pulse selective for the nuclei or spins of the said second group (X) and for uncoupled nuclei or spins, and thereafter to a magnetic gradient field pulse that is dephasing for the nuclei or spins of the said second group (X).

8. Method according to one or more of claims 1 to 7, **wherein** the said first and the second magnetic gradient field pulse (17, 23; 68/69, 70) are positioned at the time axis (t), relative to the r.f. pulses (13, 22; 61, 62), in such a way that no stimulated echoes of uncoupled spins are generated.

9. Method according to one or more of claims 1 to 8, **wherein** a 180° r.f. pulse (50, 51; 80, 81) is irradiated upon the said sample (30; 40) in the middle of the time interval between the said first pulse (10; 60) and the r.f. pulse (13; 61) effecting the polarization transfer, and following the r.f. pulse (22; 62) effecting the polarization retransfer.

10. Method according to one or more of claims 1 to 9, **wherein** the time interval ($\tau_1$) between the said first r.f. pulse (10; 60) and the said second r.f. pulse (13; 61) is selected to be equal to an odd multiple of the reciprocal value of twice the coupling constant (J) between the first group (A) and the second group (X).

11. Method according to one or more of claims 1 to 9, **wherein** for an $A_n X_2$ system the time interval ($\tau_1$) between the said first r.f. pulse (10; 60) and the said second r.f. pulse (13; 61) is determined according to the formula

$$\tau 1 = \frac{1}{\Pi\, J}\, \text{arc cot}\, \frac{1}{\Pi\, J\, T_2}$$

wherein J is the coupling constant between the said first group (A) and the said second group (X) and $T_2$ is the transversal relaxation time.

12. Method according to one or more of claims 1 to 9, **wherein** for an $A_n X_2$ system the time interval ($\tau_1$) between the said first r.f. pulse (10; 60) and the said second r.f. pulse (13; 61) is determined according to the formula

$$\tau 1 = \frac{1}{2\,\Pi\, J}\, \text{arc cot}\, \frac{1}{2\,\Pi\, J\, T_2}$$

wherein J is the coupling constant between the said first group (A) and the said second group (X) and $T_2$

is the transversal relaxation time.

**13.** Method according to one or more of claims 3 to 12, **wherein** the time interval ($\tau_2$) between the third r.f. pulse (63) and the fourth r.f. pulse (64) is selected to be equal to an integer multiple of the said coupling constant (J) between the said first group (A) and the said second group (X).

**14.** Method according to one or more of claims 5 to 13, **wherein** for imaging purposes a volume-selective measurement is taken in a conventional manner on a plurality of areas of said the sample (30; 40).

**Revendications**

**1.** Procédé d'enregistrement de spectres de résonance magnétique nucléaire sur des échantillons (30 ; 40) comprenant au moins trois groupes (A, B, X) de noyaux de même type, un premier groupe (A) étant couplé avec un second groupe (X), tandis qu'un troisième groupe (B) n'est pas couplé avec le second groupe (X) mais présente un déplacement chimique qui ne correspond substantiellement qu'à celui du premier groupe (A), le signal du troisième groupe (B) étant supprimé pour la représentation exclusive du signal du premier groupe (A), <u>caractérisé</u> en ce que :
- un train d'impulsions constitué par trois impulsions haute fréquence, de préférence des impulsions haute fréquence décalées de 90° (10, 13, 22), est envoyé sur l'échantillon (30 ; 40),
- la seconde impulsion haute fréquence (13) est réglée de telle sorte que la magnétisation des noyaux du premier groupe (A) est transmise par transfert de polarisation aux noyaux du second groupe (X),
- dans l'intervalle de temps ($\tau_2$) qui sépare la seconde impulsion haute fréquence (13) de la troisième impulsion haute fréquence (22) est appliquée à l'échantillon (30 ; 40) une première impulsion de champ magnétique à gradients (17) qui déphase les noyaux du second groupe (X),
- la troisième impulsion haute fréquence (22) est réglée de telle sorte que la magnétisation des noyaux du second groupe (X) est à nouveau transmise par retransfert de polarisation aux noyaux du premier groupe (A), et
- une seconde impulsion de champ magnétique à gradients (17, 23), qui remet en phase les noyaux du premier groupe (A), est ensuite appliquée à l'échantillon (30 ; 40).

**2.** Procédé selon la revendication 1, caractérisé en ce que l'échantillon (30 ; 40) est un échantillon de lactate.

**3.** Procédé d'enregistrement de spectres de résonance magnétique nucléaire sur des échantillons comprenant au moins trois groupes (A, B, X) de noyaux, un premier groupe (A) d'un premier type de noyau étant couplé avec un second groupe (X) d'un second type de noyau, tandis qu'un troisième groupe (B) du premier type de noyau n'est pas couplé avec le second groupe (X) mais présente un déplacement chimique qui ne correspond substantiellement qu'à celui du premier groupe (A), le signal du troisième groupe (B) étant supprimé pour la représentation exclusive du signal du premier groupe (A), caractérisé en ce que :
- un train d'impulsions constitué par cinq impulsions haute fréquence, de préférence des impulsions haute fréquence décalées de 90° (60 à 64), est envoyé sur l'échantillon,
- la seconde impulsion haute fréquence (61) et la troisième impulsion haute fréquence (63) sont réglées de telle sorte que la magnétisation des noyaux du premier groupe (A) appartenant au premier type de noyau soit transmise par transfert de polarisation aux noyaux du second groupe (X) appartenant au second type de noyau,
- dans l'intervalle de temps ($\tau_2$) qui sépare la troisième impulsion haute fréquence (63) de la quatrième impulsion haute fréquence (64) est appliquée à l'échantillon au moins une impulsion de champ magnétique à gradients (68, 69) qui déphase les noyaux du second groupe (X),
- une quatrième impulsion haute fréquence (64) et une cinquième impulsion haute fréquence (62) sont réglées de telle sorte que la magnétisation des noyaux du second groupe (X) est à nouveau transmise par retransfert de polarisation aux noyaux du premier groupe (A), et
- une seconde impulsion de champ magnétique à gradients (70), qui remet en phase les noyaux du premier groupe (A), est ensuite appliquée à l'échantillon.

**4.** Procédé d'enregistrement de spectres de résonance de spins sur des échantillons comprenant au moins trois groupes (A, B, X) de spins, un premier groupe (A) étant couplé avec un second groupe (X), tandis qu'un troisième groupe (B) n'est pas couplé avec le second groupe (X) mais présente un signal dont la position spectrale ne correspond substantiellement qu'à celle du premier groupe (A), le signal du troisième groupe (B) étant supprimé pour la représentation exclusive du signal du premier groupe (A), caractérisé en ce que :

- un train d'impulsions constitué par au moins trois impulsions haute fréquence, de préférence des impulsions haute fréquence décalées de 90°, est envoyé sur l'échantillon,
- au moins la seconde impulsion haute fréquence est réglée de telle sorte que la magnétisation des spins du premier groupe (A) est transmise par transfert de polarisation aux spins du second groupe (X),
- après la seconde impulsion haute fréquence, au moins une première impulsion de champ magnétique à gradients qui déphase les spins du second groupe (X) est appliquée à l'échantillon,
- l'une au moins des autres impulsions haute fréquence est réglée de telle sorte que la magnétisation des spins du second groupe (X) est ensuite transmise à nouveau par retransfert de polarisation aux spins du premier groupe (A), et
- une seconde impulsion de champ magnétique à gradients, qui remet en phase les spins du premier groupe (A), est enfin appliquée à l'échantillon.

5. Procédé selon l'une ou plusieurs des revendications 1 à 4, caractérisé en ce que, pour une représentation à sélection de volume, l'échantillon (30 ; 40) est soumis, d'une façon connue en soi, à un train d'impulsions de champ magnétique à gradients (11, 12, 14, 15, 17, 18, 19, 20, 21, 23, 24 ; 66 à 76) selon différents axes de coordonnées (x, y, z), et que trois, au moins, des impulsions haute fréquence (10, 13, 22 ; 60, 61, 62) sont réglées avec une sélection de tranche.

6. Procédé selon l'une ou plusieurs des revendications 1 à 5, caractérisé en ce qu'après l'impulsion haute fréquence (13 ; 63), provoquant le transfert de polarisation, est envoyée une autre impulsion haute fréquence, de préférence une impulsion haute fréquence (16 ; 65) décalée à 180°, sélective en ce qui concerne le déplacement chimique des noyaux ou des spins du second groupe (X).

7. Procédé selon l'une ou plusieurs des revendications 1 à 6, caractérisé en ce qu'avant l'application des premières impulsions haute fréquence (10 ; 60) est envoyée sur l'échantillon (30 ; 40) une impulsion haute fréquence de présaturation sélective pour les noyaux ou spins du second groupe (X) ainsi que pour les noyaux ou spins non couplés, suivie d'une impulsion de champ magnétique à gradients, sélective pour les noyaux ou spins du second groupe (X).

8. Procédé selon l'une ou plusieurs des revendications 1 à 7, caractérisé en ce que la première et la seconde des impulsions de champ magnétique à gradients (17, 23 ; 68 / 69, 70) sont positionnées sur l'axe des temps (t), par rapport aux impulsions haute fréquence (13, 22 ; 61, 62), de telle sorte qu'il ne produise aucun écho stimulé de spins non couplés.

9. Procédé selon l'une ou plusieurs des revendications 1 à 8, caractérisé en ce qu'au milieu du temps qui sépare la première (10 ; 60) impulsion haute fréquence de celle qui provoque le transfert de polarisation (13 ; 61) ainsi qu'après l'impulsion haute fréquence (22 ; 62) qui provoque le retransfert de polarisation, une impulsion décalée à 180° (50, 51 ; 80, 81) est appliquée à chaque fois sur l'échantillon (30 ; 40).

10. Procédé selon l'une ou plusieurs des revendications 1 à 9, caractérisé en ce que l'intervalle de temps ($\tau_1$) qui sépare la première impulsion haute fréquence (10 ; 60) de la seconde impulsion haute fréquence (13 ; 61) est égal à un nombre impair de fois l'inverse du double de la constante de couplage (J) entre le premier groupe (A) et le second groupe (X).

11. Procédé selon l'une ou plusieurs des revendications 1 à 9, caractérisé en ce que pour un système $A_nX$, l'intervalle de temps ($\tau_1$) qui sépare la première impulsion haute fréquence (10 ; 60) de la seconde impulsion haute fréquence (13 ; 61), est donné par la formule :

$$\tau_1 = \frac{1}{\Pi J} \text{ arc cot } \frac{1}{\Pi J T_2}$$

dans laquelle J est la constante de couplage entre le premier groupe (A) et le second groupe (X), et $T_2$ est le temps de relaxation transversale.

12. Procédé selon l'une ou plusieurs des revendications 1 à 9, caractérisé en ce que pour un système $A_nX_2$, l'intervalle de temps ($\tau_1$) qui sépare la première impulsion haute fréquence (10 ; 60) de la seconde impulsion haute fréquence (13 ; 61), est donné par la formule :

$$\tau_1 \;=\; \frac{1}{2\Pi J}\, \text{arc cot}\, \frac{1}{2\Pi J T_2}$$

dans laquelle J est la constante de couplage entre le premier groupe (A) et le second groupe (X), et $T_2$ est le temps de relaxation transversale.

13. Procédé selon l'une ou plusieurs des revendications 3 à 12, caractérisé en ce que l'intervalle de temps ($\tau_2$) qui sépare la troisième impulsion haute fréquence (63) de la quatrième impulsion haute fréquence (64) est égal à un nombre entier de fois la constante de couplage (J) entre le premier groupe (A) et le second groupe (X).

14. Procédé selon l'une ou plusieurs des revendications 5 à 13, caractérisé en ce que, pour une représentation imagée, une mesure à sélection de volume est effectuée, d'une façon connue en soi, sur un ensemble de zones de l'échantillon (30 ; 40).

FIG.1

FIG. 2

EP 0 422 172 B1

FIG. 3

FIG.4

FIG.5

FIG. 6

32

30

31

X

3.0  2.0  1.0  0.0
PPM

3.0  2.0  1.0  0.0
PPM

3.0  2.0  1.0  0.0
PPM

FIG. 7

FIG. 8

FIG. 9

FIG. 10

EP 0 422 172 B1

FIG. 11

FIG.13

FIG.12

AQ

DC

ppm

¹H

¹³C

Gx

Gy

Gz

τ₁  τ₂  τ₃  t

10ms

EP 0 422 172 B1

24

FIG. 14

FIG.15

FIG.16

Skalierungsfaktor 1

PPM
8.0  7.0  6.0  5.0  4.0  3.0  2.0  1.0  0.0

FIG.17

Skalierungsfaktor 2

PPM
8.0  7.0  6.0  5.0  4.0  3.0  2.0  1.0  0.0